# EUROPEAN PATENT APPLICATION

(11) **EP 4 401 309 A1**
(43) Date of publication of application: **17.07.2024**
(21) Application number: 22866491.8
(22) Date of filing: 31.08.2022
(51) Int. Cl.: H03H 9/02, H03H 9/56

(54) **BULK ACOUSTIC WAVE RESONANCE DEVICE, FILTER DEVICE, AND RADIO FREQUENCY FRONT-END DEVICE**

(30) Priority: 08.09.2021 CN 202111041933
(71) Applicant: Changzhou Chemsemi Co., Ltd., Changzhou, Jiangsu 213166 (CN)
(72) Inventor: ZOU, Yali, Changzhou, Jiangsu 213166 (CN)
(74) Representative: Piticco, Lorena
(86) International application number: PCT/CN2022/116064
(87) International publication number: WO 2023/036026

(57) **Abstract**

Provided in the present embodiment are a bulk acoustic wave resonance device, a filter device and a radio frequency front-end device. The bulk acoustic wave resonance device comprises: a first layer comprising a cavity; a first electrode layer having at least one end located in the cavity; a piezoelectric layer, which is located on the first electrode layer to cover the cavity and comprises a first side and a second side opposite the first side, the first electrode layer being located on the first side; a second electrode layer located on the second side and on the piezoelectric layer, the portion of the second electrode layer that overlaps the first electrode layer being located above the cavity and corresponding to the cavity; and a first composite structure, which is located on the first side, comes into contact with the piezoelectric layer, and is adjacent to the first electrode layer in a horizontal direction, wherein a first end of the first composite structure close to the first electrode layer is located in the cavity, and a second end thereof opposite the first end in the horizonal direction and away from the first electrode layer is embedded into the first layer, and the first composite structure comprises a first edge extension layer and a first support layer that is located between the piezoelectric layer and the first edge extension layer. The bulk acoustic wave resonance device is used to reduce fringe capacitance, increase an electromechanical coupling coefficient, and block leaky waves, thereby increasing a Q value.

## Description

### CROSS-REFERENCE TO RELATED APPLICATIONS

This application claims the benefit of priority to Chinese Patent Application No. 2021110419331, filed on September 8, 2021 with China National Intellectual Property Administration, and entitled "BULK ACOUSTIC WAVE RESONANCE DEVICE, FILTER DEVICE, AND RADIO FREQUENCY FRONT-END DEVICE", the entire disclosure of which is incorporated herein by reference.

### TECHNICAL FIELD

The present disclosure relates to the field of semiconductor, and particularly, to a bulk acoustic wave resonance device, a filtering device, and a radio frequency front-end device.

### BACKGROUND

A Radio Frequency (RF) front-end chip of a wireless communication device includes a power amplifier, an antenna switch, a radio frequency filter, a multiplexer, and a low noise amplifier, and the like. Wherein, the radio frequency filter includes a piezoelectric Surface Acoustic Wave (SAW) filter, a piezoelectric Bulk Acoustic Wave (BAW) filter, a Micro-Electro-Mechanical System (MEMS) filter, an Integrated Passive Device (IPD) filter, and the like.

As both a SAW resonator and a BAW resonator have a relatively high quality factor value (Q value), a radio frequency filter based on either a SAW resonator, namely a SAW filter, or a BAW resonator, namely a BAW filter, has low insertion loss and high out-of-band rejection, and thus becomes a mainstream radio frequency filter applied to current wireless communication devices, such as, mobile phones, base stations, and the like. Wherein, the Q value is a quality factor value of a resonator, and is defined to be a center frequency divided by 3 dB bandwidth of the resonator. A SAW filter typically works at a frequency ranging from 0.4 GHz to 2.7 GHz. And, a BAW filter typically works at a frequency ranging from 0.7 GHz to 7 GHz.

BAW resonators have better performance than SAW resonators, but with a higher manufacturing cost than SAW resonators due to more complex process steps. However, with gradual evolution of wireless communication technology, more and more frequency bands are applied. Moreover, due to application of frequency band superposition technology such as carrier aggregation, mutual interference between wireless frequency bands becomes raising more serious. The problem of mutual interference between frequency bands can be solved by high performance BAW technology. With the advent of the 5G era, wireless mobile networks have adopted higher communication frequency bands, and only BAW technology can provide solutions to the filtering problem in the high frequency bands so far.

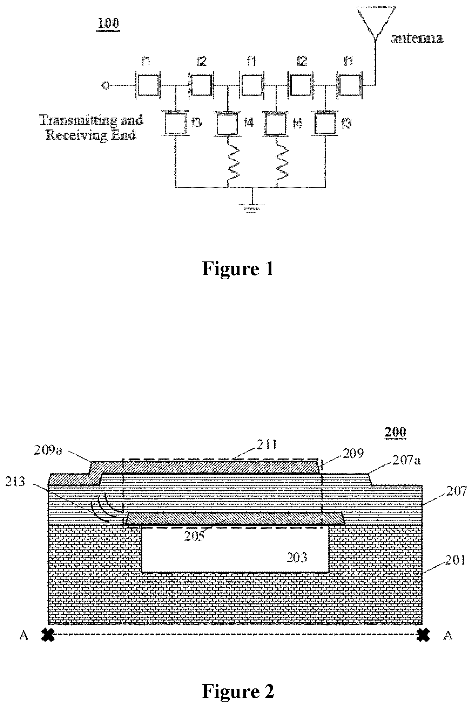

Figure 1 shows a circuit 100 of a BAW filter, which includes a ladder circuit consisting of BAW resonators, and f1, f2, f3, f4 represent 4 different frequencies, respectively. In each of the BAW resonators, alternating positive and negative voltages are applied to metal electrodes at two sides of a piezoelectric layer of the resonator, and acoustic waves are generated by the piezoelectric layer under the alternating positive and negative voltages and propagates in a direction perpendicular to the piezoelectric layer. In order to form resonance, the acoustic waves require total reflection on an upper surface of an upper metal electrode and on a lower surface of a lower metal electrode to form standing acoustic waves. A condition for reflection of acoustic waves is that acoustic impedance of medium contacting the upper surface of the upper metal electrode and the lower surface of the lower metal electrode differs greatly from acoustic impedance of the metal electrodes.

Film Bulk Acoustic Wave Resonator (FBAR) is a kind of BAW resonator that can restrain acoustic energy inside the resonator, and air or vacuum is at one side of a resonance region of the resonator and a cavity is at the other side of the resonance region. Acoustic impedance of air and vacuum is quite different from that of metal electrodes, thus acoustic waves can be completely reflected on an upper surface of an upper metal electrode and on a lower surface of a lower metal electrode to form standing waves.

Figure 2 shows a schematic structural view of section A of an FBAR 200. The FBAR 200 includes a substrate 201, which includes a cavity 203; an electrode layer 205 (i.e., a lower electrode layer), which is disposed on the substrate 201 and covers the cavity 203; a piezoelectric layer 207, which is disposed on the substrate 201, covers the electrode layer 205, and includes a protrusion 207a disposed above the electrode layer 205; and an electrode layer 209 (i.e., an upper electrode layer), which is disposed on the piezoelectric layer 207, includes a protrusion 209a disposed on the protrusion 207a. It is noted that outside a resonance region 211, fringe capacitance 213 exists between the electrode layer 205 and the electrode layer 209, resulting in acoustic energy loss, and thereby lowering electro-mechanical coupling factor and Q value of the resonator.

### SUMMARY

The present disclosure is to provide a bulk acoustic wave resonance device, which may reduce fringe capacitance, improve electro-mechanical coupling factor and prevent leaky waves, as well as raise Q value.

Embodiments of the present disclosure provides a bulk acoustic wave resonance device including: a first layer that includes a cavity; a first electrode layer, which has at least one end disposed in the cavity; a piezoelectric layer, which is disposed on the first electrode layer and covers the cavity; wherein the piezoelectric layer includes a first side and a second side opposite to the first side along a vertical direction, and the first electrode layer is disposed at the first side; a second electrode layer, which is disposed at the second side and on the piezoelectric layer; wherein the second electrode layer has an overlap with the first electrode layer, where the overlap is disposed above and corresponding to the cavity; and a first composite structure, which is disposed at the first side and contacts the piezoelectric layer, where the first composite structure is adjacent to the first electrode layer along a horizontal direction; wherein a first end of the first composite structure, which is close to the first electrode layer, is disposed in the cavity, and a second end of the first composite structure, which is far away from the first electrode layer and opposite to the first end along a horizontal direction, is embedded in the first layer; wherein, the first composite structure includes a first edge extension layer and a first support layer disposed between the piezoelectric layer and the first edge extension layer, where the first support layer is adapted to lower fringe capacitance.

According to some embodiments, the first edge extension layer may be made of a material including a metal.

According to some embodiments, the first support layer may include a medium including, but not limited to, one of non-metallic materials, air, and vacuum.

According to some embodiments, the first electrode layer is in a polygonal shape, and the first composite structure is adjacent to at least one side of the first electrode layer.

According to some embodiments, the bulk acoustic wave resonance device further includes a first edge structure, which is disposed at the first side and contacts the piezoelectric layer, where the first edge structure includes a third side and a fourth side opposite to the third side along a horizontal direction; wherein the first electrode layer is disposed at the third side, and the first composite structure is disposed at the fourth side.

According to some embodiments, the first edge structure may enclose at least part of the first electrode layer.

According to some embodiments, the first electrode layer is disposed at an inner side of the first edge structure, and the first composite structure is disposed at an outer side of the first edge structure. It should be noted that, the inner side refers to a side that directs to a central axis of the bulk acoustic wave resonance device, and the outer side is opposite to the inner side along a horizontal direction.

According to some embodiments, the first edge structure may include a first edge frame layer, which may be made of a material including a metal, connected to the first electrode layer, and further connected to the first edge extension layer.

According to some embodiments, the first edge structure may further include a first edge support layer, which may contact the piezoelectric layer and be disposed between the piezoelectric layer and the first edge frame layer, where the first edge support layer is adapted to lower a resonance frequency of a spurious resonance excited due to the first edge frame layer.

According to some embodiments, the first edge support layer may include a medium including one of non-metallic materials, air, and vacuum.

According to some embodiments, the first edge structure may include a first overlap with the second electrode layer.

According to some embodiments, the first composite structure may include a second overlap with the second electrode layer, and the second overlap may have a width equal to a width of the first edge structure.

According to some embodiments, the first edge structure is in a polygonal shape, and the first composite structure is adjacent to at least one side of the first edge structure.

According to some embodiments, the first composite structure may further include a first edge part, which includes a fifth side and a sixth side opposite to the fifth side along a horizontal direction, where the first electrode layer is disposed at the fifth side, the first edge extension layer and the first support layer are disposed at the sixth side.

According to some embodiments, the first edge part may have a thickness equal to a sum of a thickness of the first edge extension layer and a thickness of the first support layer.

According to some embodiments, the first edge part may enclose at least part of the first electrode layer.

According to some embodiments, the first electrode layer is disposed at an inner side of the first edge part, and the first edge extension layer and the first support layer are disposed at an outer side of the first edge part.

According to some embodiments, the first edge part may include a third overlap with the second electrode layer.

According to some embodiments, the first edge extension layer may include a fourth overlap with the first support layer and the second electrode layer, and the fourth overlap may have a width equal to a width of the first edge part.

According to some embodiments, the first edge part is in a polygonal shape, and the first edge extension layer and the first support layer are adjacent to at least one side of the first edge part.

It should be noted that, a composite structure is electrically connected to a first electrode layer or an edge structure of the first electrode, which includes an edge extension layer and a composite support layer, and the composite support layer may raise a thickness of dielectric between the edge extension layer and a second electrode layer, resulting in lowering fringe capacitance, improving electro-mechanical coupling factor, preventing leaky waves, and raising Q value.

The embodiments of the present disclosure further provide a bulk acoustic wave resonance device including: a first layer that includes a cavity; a first electrode layer, which has at least one end disposed in the cavity; a piezoelectric layer, which is disposed on the first electrode layer and covers the cavity, and the piezoelectric layer includes a first side and a second side opposite to the first side along a vertical direction; wherein the first electrode layer is disposed at the first side, and a second electrode layer is disposed at the second side and on the piezoelectric layer; wherein, the second electrode layer has an overlap with the first electrode layer, where the overlap is disposed above and corresponding to the cavity; and a second composite structure, which is disposed at the second side and contacts the piezoelectric layer; wherein the second composite structure is adjacent to the second electrode layer along a horizontal direction and does not overlap with or partially overlaps with the first electrode layer, where the second composite structure includes a second edge extension layer and a second support layer disposed between the piezoelectric layer and the second edge extension layer, where the second support layer is adapted to lower fringe capacitance.

According to some embodiments, the second edge extension layer may be made of a material including a metal.

According to some embodiments, the second support layer may include a medium including one of non-metallic materials, air, and vacuum.

According to some embodiments, the second electrode layer is in a polygonal shape, and the second composite structure is adjacent to at least one side of the second electrode layer.

According to some embodiments, the bulk acoustic wave resonance device further includes a second edge structure, which is disposed at the second side and contacts the piezoelectric layer, and the second edge structure includes a third side and a fourth side opposite to the third side along a horizontal direction; wherein, the second electrode layer is disposed at the third side, and the second composite structure is disposed at the fourth side.

According to some embodiments, the second edge structure may enclose at least part of the second electrode layer.

According to some embodiments, the second electrode layer is disposed at an inner side of the second edge structure, and the second composite structure is disposed at an outer side of the second edge structure.

According to some embodiments, the second edge structure further includes a second edge frame layer, which may be made of a material including a metal, where the edge frame layer is connected to the second electrode layer and further connected to the second edge extension layer.

According to some embodiments, the second edge structure may further include a second edge support layer, which contacts the piezoelectric layer and is disposed between the piezoelectric layer and the second edge frame layer, where the second edge support layer is adapted to lower a resonance frequency of a spurious resonance excited due to the second edge frame layer.

According to some embodiments, the second edge support layer may include a medium including one of non-metallic materials, air, and vacuum.

According to some embodiments, the second edge structure may include a first overlap with the first electrode layer.

According to some embodiments, the second composite structure may include a second overlap with the first electrode layer, and the second overlap may have a width equal to the width of the second edge structure.

According to some embodiments, the second edge structure is in a polygonal shape, and the second composite structure is adjacent to at least one side of the second edge structure.

According to some embodiments, the second composite structure may further include a second edge part, which includes a fifth side and a sixth side opposite to the fifth side along a horizontal direction; wherein, the second electrode layer is disposed at the fifth side, and the second edge extension layer and the second support layer are disposed at the sixth side.

According to some embodiments, the second edge part may have a thickness equal to a sum of a thickness of the second edge extension layer and a thickness of the second support layer.

According to some embodiments, the second edge part may enclose at least part of the second electrode layer.

According to some embodiments, the second electrode layer is disposed at an inner side of the second edge part, and the second edge extension layer and the second support layer are disposed at an outer side of the second edge part.

According to some embodiments, the second edge part may include a third overlap with the first electrode layer.

According to some embodiments, the second edge extension layer may include a fourth overlap with the second support layer and the first electrode layer, and the fourth overlap may have a width equal to a width of the second edge part.

According to some embodiments, the second edge part is in a polygonal shape, and the second edge extension layer and the second support layer are adjacent to at least one side of the second edge part.

It should be noted that, a composite structure is electrically connected to a second electrode layer or an edge structure corresponding to the second electrode layer and includes an edge extension layer and a compound support layer, and the compound support layer may raise a thickness of dielectric between the edge extension layer and the first electrode layer, thereby lowering fringe capacitance, improving electro-mechanical coupling factor, preventing leaky waves, and raising Q value.

According to some embodiments, the first layer may include an intermediate layer, which includes the cavity and is made of a material including, but not limited to, at least one of polymers, insulating dielectric, and polysilicon.

The embodiments of the present disclosure further provide a filtering device, which includes, but is not limited to, at least one of the bulk acoustic wave resonance devices provided by at least one of the above embodiments.

The embodiments of the present disclosure further provide a radio frequency front-end device, which includes, but is not limited to, a power amplifier device and the filtering device provided by at least one of the above embodiments, and the power amplifier device is connected to the filtering device.

The embodiments of the present disclosure further provide a radio frequency front-end device, which includes, but is not limited to, a low noise amplifier device and the filtering device provided by at least one of the above embodiments, and the low noise amplifier device is connected to the filtering device.

The embodiments of the present disclosure further provide a radio frequency front-end device, which includes, but is not limited to, a multiplexing device including the filtering device provided by at least one of the above embodiments.

### BRIEF DESCRIPTION OF THE DRAWINGS

Figure 1 is a schematic structural view of a BAW filter circuit 100;
Figure 2 is a schematic structural view of section A of an FBAR 200;
Figure 3a is a schematic structural view of section A of a bulk acoustic wave resonance device 300 according to an embodiment of the present disclosure;
Figure 3b is a schematic view of acoustic impedance of a bulk acoustic wave resonance device 300 according to an embodiment of the present disclosure;
Figure 3c is a schematic view of performance of a bulk acoustic wave resonance device 300 according to an embodiment of the present disclosure;
Figure 3d is a schematic view of a structure of a hexagonal crystal grain;
Figure 3e(i) is a schematic view of a structure of an orthorhombic crystal grain;

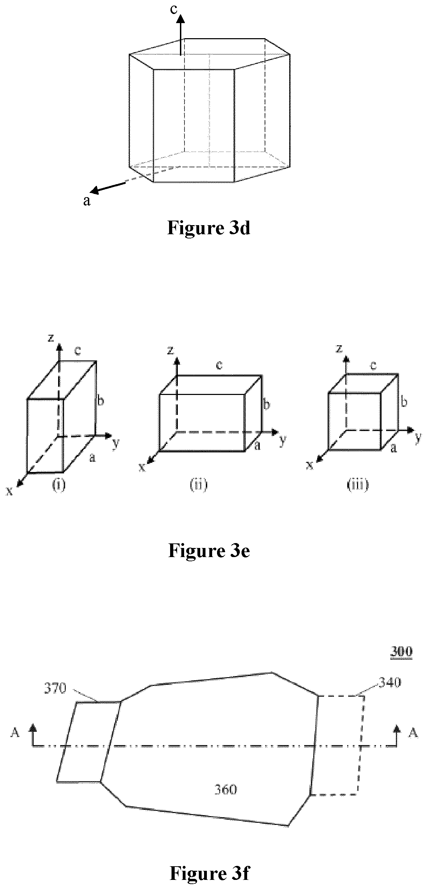

Figure 3e(ii) is a schematic view of a structure of a tetragonal crystal grain;
Figure 3e(iii) is a schematic view of a structure of a cubic crystal grain;
Figure 3f is a schematic structural top view of a bulk acoustic wave resonance device 300 according to an embodiment of the present disclosure;

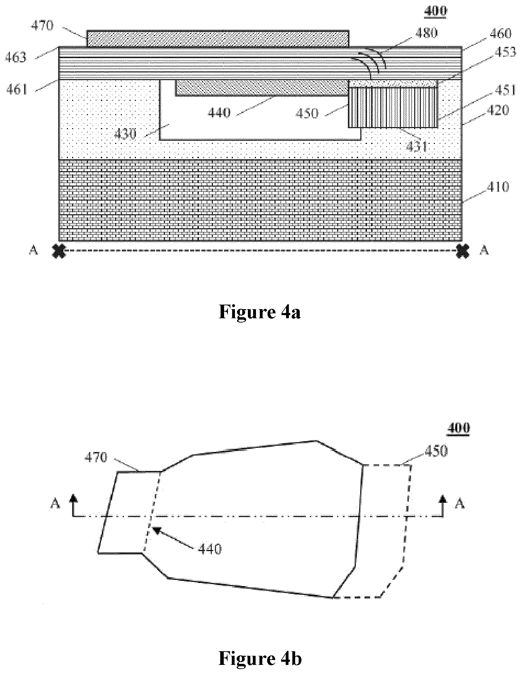

Figure 4a is a schematic structural view of section A of a bulk acoustic wave resonance device 400 according to an embodiment of the present disclosure;
Figure 4b is a schematic structural top view of a bulk acoustic wave resonance device 400 according to an embodiment of the present disclosure;

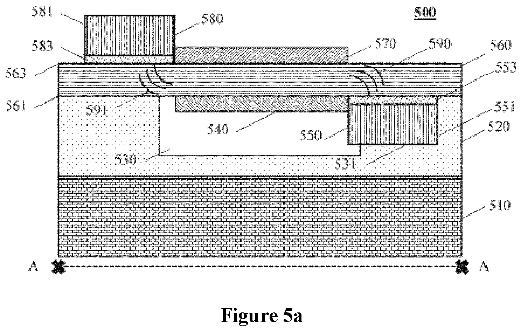

Figure 5a is a schematic structural view of section A of a bulk acoustic wave resonance device 500 according to an embodiment of the present disclosure;

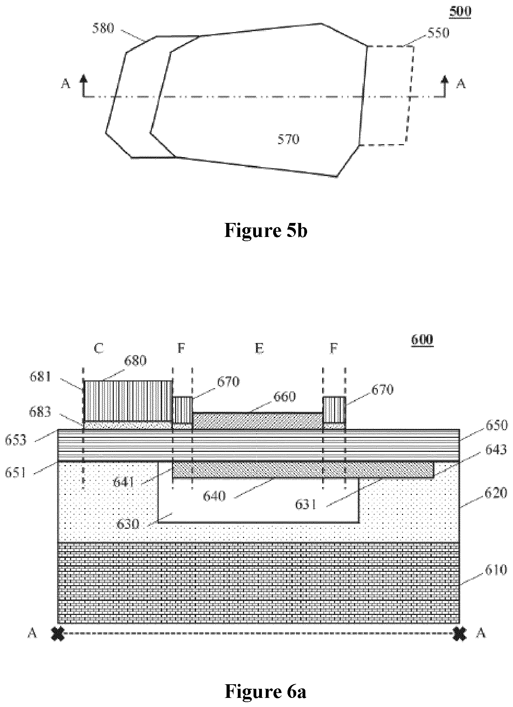

Figure 5b is a schematic structural top view of a bulk acoustic wave resonance device 500 according to an embodiment of the present disclosure;
Figure 6a is a schematic structural view of section A of a bulk acoustic wave resonance device 600 according to an embodiment of the present disclosure;

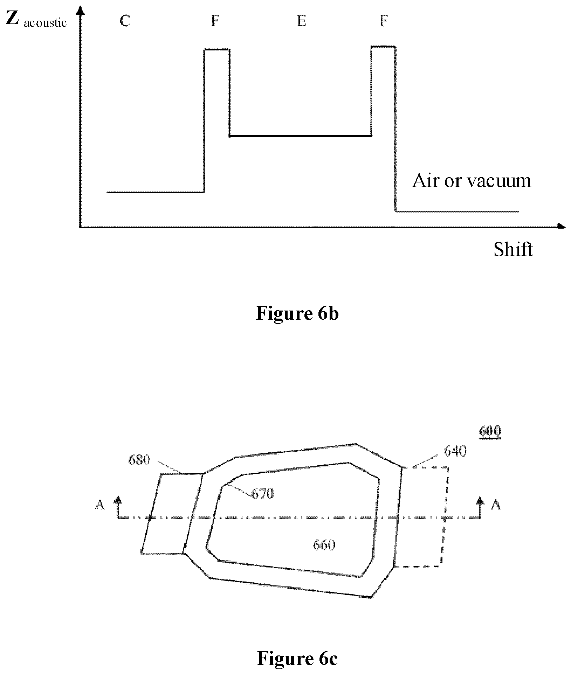

Figure 6b is a schematic view of acoustic impedance of a bulk acoustic wave resonance device 600 according to an embodiment of the present disclosure;
Figure 6c is a schematic structural top view of a bulk acoustic wave resonance device 600 according to an embodiment of the present disclosure;

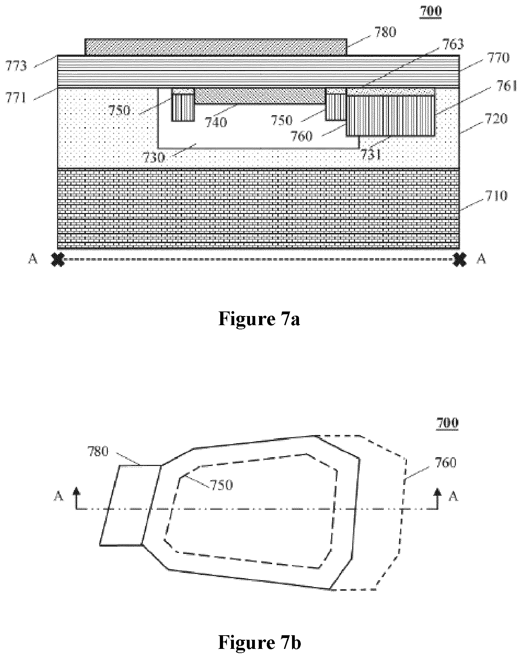

Figure 7a is a schematic structural view of section A of a bulk acoustic wave resonance device 700 according to an embodiment of the present disclosure;
Figure 7b is a schematic structural top view of a bulk acoustic wave resonance device 700 according to an embodiment of the present disclosure;

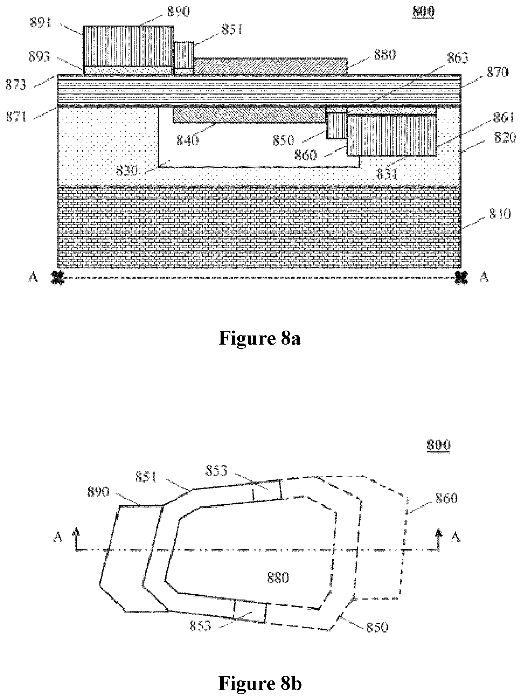

Figure 8a is a schematic structural view of section A of a bulk acoustic wave resonance device 800 according to an embodiment of the present disclosure;
Figure 8b is a schematic structural top view of a bulk acoustic wave resonance device 800 according to an embodiment of the present disclosure;

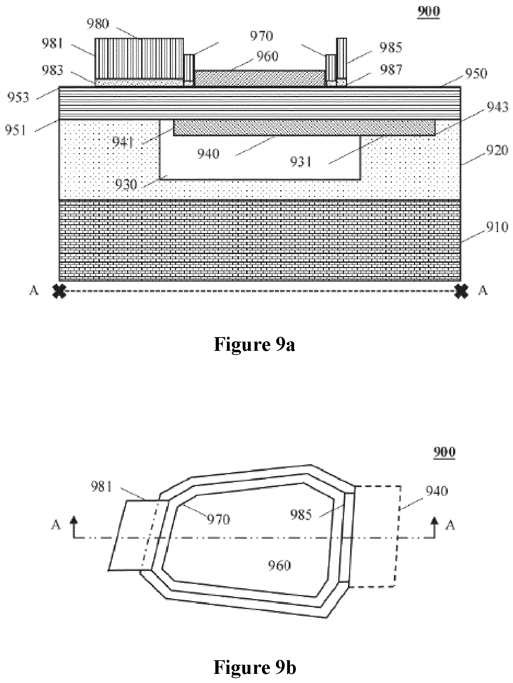

Figure 9a is a schematic structural view of section A of a bulk acoustic wave resonance device 900 according to an embodiment of the present disclosure;
Figure 9b is a schematic structural top view of a bulk acoustic wave resonance device 900 according to an embodiment of the present disclosure;

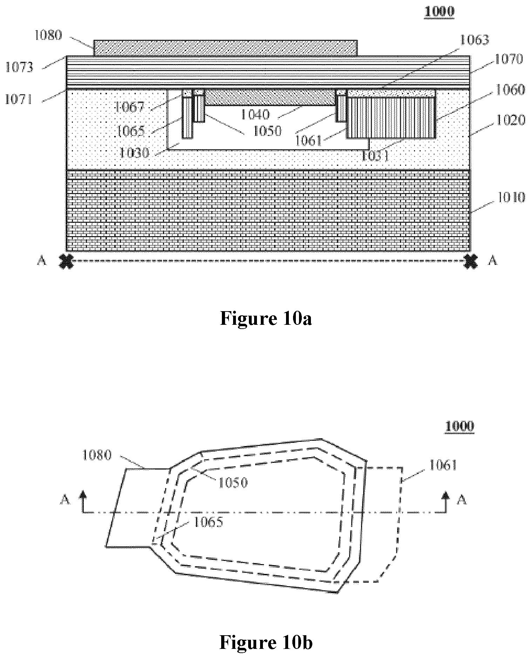

Figure 10a is a schematic structural view of section A of a bulk acoustic wave resonance device 1000 according to an embodiment of the present disclosure;
Figure 10b is a schematic structural top view of a bulk acoustic wave resonance device 1000 according to an embodiment of the present disclosure;

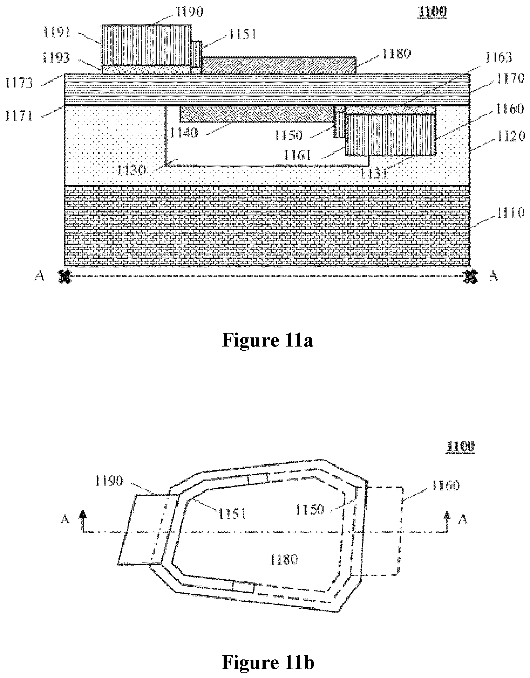

Figure 11a is a schematic structural view of section A of a bulk acoustic wave resonance device 1100 according to an embodiment of the present disclosure;
Figure 11b is a schematic structural top view of a bulk acoustic wave resonance device 1100 according to an embodiment of the present disclosure;

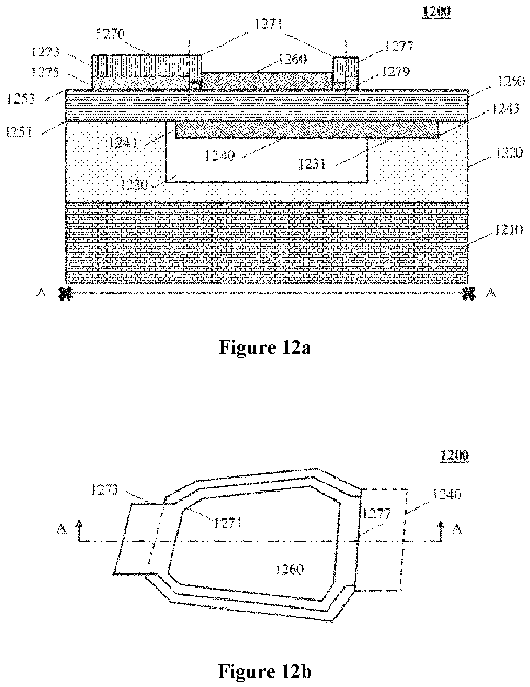

Figure 12a is a schematic structural view of section A of a bulk acoustic wave resonance device 1200 according to an embodiment of the present disclosure;
Figure 12b is a schematic structural top view of a bulk acoustic wave resonance device 1200 according to an embodiment of the present disclosure;

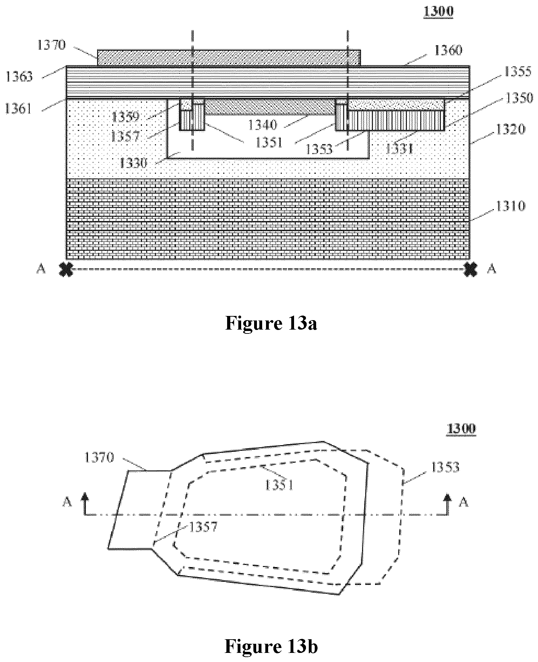

Figure 13a is a schematic structural view of section A of a bulk acoustic wave resonance device 1300 according to an embodiment of the present disclosure;
Figure 13b is a schematic structural top view of a bulk acoustic wave resonance device 1300 according to an embodiment of the present disclosure;

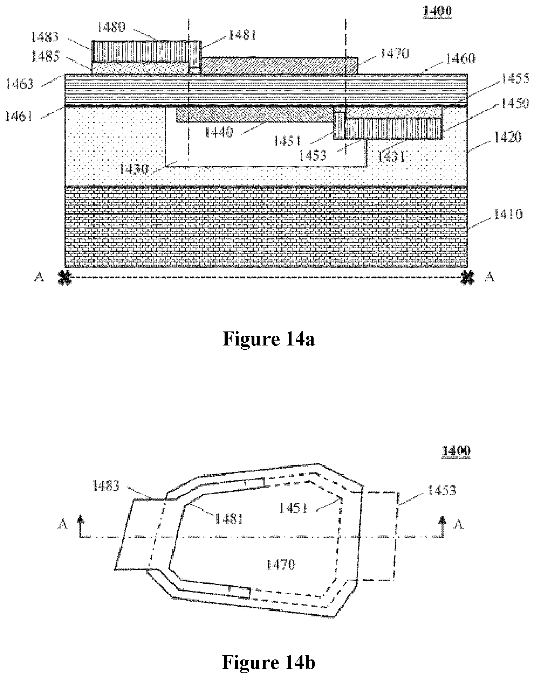

Figure 14a is a schematic structural view of section A of a bulk acoustic wave resonance device 1400 according to an embodiment of the present disclosure;
Figure 14b is a schematic structural top view of a bulk acoustic wave resonance device 1400 according to an embodiment of the present disclosure; and

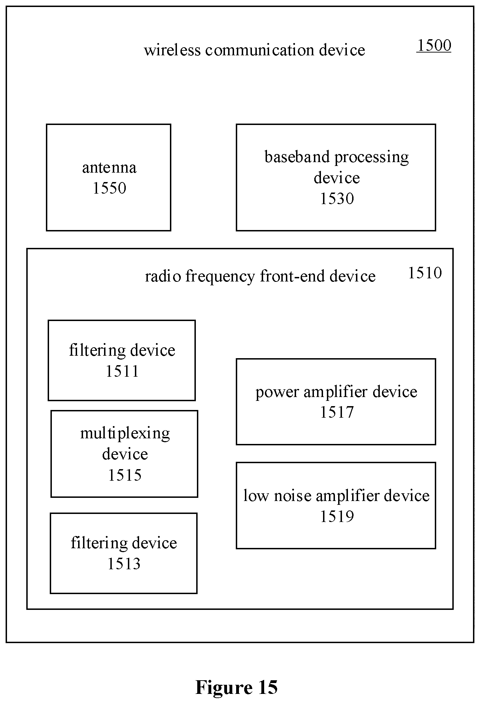

Figure 15 is a schematic structural view of a wireless communication device 1500.

### DETAILED DESCRIPTION

In order to make above-mentioned purpose, features and advantages of the present disclosure clearer and more understandable, specific embodiments of the present disclosure will be described in detail below in conjunction with the accompanying drawings.

In the following description, specific details are set forth to provide a full understanding of the present disclosure, but the present disclosure may also be implemented in other ways than those described herein, and therefore the present disclosure is not limited by the specific embodiments disclosed below.

As described in the BACKGROUND, outside a resonance region, fringe capacitance exists between an upper electrode layer and a lower electrode layer, resulting in acoustic energy loss, and thereby lowering electro-mechanical coupling factor and Q value of the resonator.

It has been found by the inventor of the present disclosure that, the BAW resonance device includes a composite structure, which is electrically connected to a first electrode layer or an edge structure of the first electrode, includes an edge extension layer and a compound support layer, and the compound support layer may raise a thickness of dielectric between the edge extension layer and the second electrode layer, thereby lowering fringe capacitance, improving electro-mechanical coupling factor, preventing leaky waves, and raising Q value. In addition, it has been also found that, the edge structure and the composite structure may form a reflection structure, which is disposed outside the first electrode layer, to reflect acoustic waves in resonance region, prevent leaky waves, and improve the Q value.

An embodiment of the present disclosure provides a bulk acoustic wave resonance device including: a first layer that includes a cavity; a first electrode layer, which has at least one end disposed in the cavity; a piezoelectric layer, which is disposed on the first electrode layer and covers the cavity, where the piezoelectric layer includes a first side and a second side opposite to the first side along a vertical direction, and the first electrode layer is disposed at the first side; a second electrode layer, which is disposed at the second side and on the piezoelectric layer, where the second electrode layer has an overlap with the first electrode layer that is disposed above and corresponding to the cavity; and a first composite structure, which is disposed at the first side and contacts the piezoelectric layer, is adjacent to the first electrode layer along a horizontal direction, where a first end of the first composite structure, which is close to the first electrode layer, is disposed in the cavity, and a second end of the first composite structure, which is far away from the first electrode layer and opposite to the first end along a horizontal direction, is embedded in the first layer; wherein, the first composite structure includes a first edge extension layer and a first support layer disposed between the piezoelectric layer and the first edge extension layer, where the first support layer is adapted to lower fringe capacitance.

According to some embodiments, the first edge extension layer may be made of a material including a metal.

According to some embodiments, the first support layer may include a medium including, but not limited to, one of non-metallic materials, air, and vacuum.

According to some embodiments, the first electrode layer is in a polygonal shape, and the first composite structure is adjacent to at least one side of the first electrode layer.

According to some embodiments, the bulk acoustic wave resonance device further includes a first edge structure, which is disposed at the first side and contacts the piezoelectric layer, and the first edge structure includes a third side and a fourth side opposite to the third side along a horizontal direction; wherein, the first electrode layer is disposed at the third side, and the first composite structure is disposed at the fourth side.

According to some embodiments, the first edge structure may enclose at least part of the first electrode layer.

According to some embodiments, the first electrode layer is disposed at an inner side of the first edge structure, and the first composite structure is disposed at an outer side of the first edge structure. It should be noted that, the inner side refers to a side that directs to a central axis of the bulk acoustic wave resonance device, and the outer side is opposite to the inner side.

According to some embodiments, the first edge structure may include a first edge frame layer, which may be made of a material including a metal, and the edge frame layer is connected to the first electrode layer and further connected to the first edge extension layer.

According to some embodiments, the first edge structure may further include a first edge support layer, which may contact the piezoelectric layer and disposed between the piezoelectric layer and the first edge frame layer. It should be noted that, the edge support layer may reduce a resonance frequency of a spurious resonance excited due to the edge frame layer and move the spurious resonance out of a main resonance region.

According to some embodiments, the first edge support layer may include a medium including one of non-metallic materials, air, and vacuum.

According to some embodiments, the first edge structure may include a first overlap with the second electrode layer.

According to some embodiments, the first composite structure may include a second overlap with the second electrode layer, and the second overlap may have a width equal to the width of the first edge structure.

According to some embodiments, the first edge structure is in a polygonal shape, and the first composite structure is adjacent to at least one side of the first edge structure.

According to some embodiments, the first composite structure may further include a first edge part, which includes a fifth side and a sixth side opposite to the fifth side along a horizontal direction, where the first electrode layer is disposed at the fifth side, and the first edge extension layer and the first support layer are disposed at the sixth side.

According to some embodiments, the first edge part may have a thickness equal to a sum of a thickness of the first edge extension layer and a thickness of the first support layer.

According to some embodiments, the first edge part may enclose at least part of the first electrode layer.

According to some embodiments, the first electrode layer is disposed at an inner side of the first edge part, and the first edge extension layer and the first support layer are disposed at an outer side of the first edge part.

According to some embodiments, the first edge part may include a third overlap with the second electrode layer.

According to some embodiments, the first edge extension layer may include a fourth overlap with the first support layer and the second electrode layer, and the fourth overlap may have a width equal to the width of the first edge part.

According to some embodiments, the first edge part is in a polygonal shape, and the first edge extension layer and the first support layer are adjacent to at least one side of the first edge part.

It should be noted that, a composite structure is electrically connected to a first electrode layer or an edge structure corresponding to the first electrode layer, and the composite structure includes an edge extension layer and a compound support layer, and the compound support layer may raise a thickness of dielectric between the edge extension layer and the second electrode layer, thereby lowering fringe capacitance, improving electro-mechanical coupling factor, preventing leaky waves, and raising Q value.

An embodiment of the present disclosure further provides a bulk acoustic wave resonance device including: a first layer that includes a cavity; a first electrode layer, which has at least one end disposed in the cavity; a piezoelectric layer, which is disposed on the first electrode layer and covers the cavity, includes a first side and a second side opposite to the first side along a vertical direction, and the first electrode layer is disposed at the first side; a second electrode layer, which is disposed at the second side and on the piezoelectric layer, has an overlap with the first electrode layer that is disposed above and corresponding to the cavity; and a second composite structure, which is disposed at the second side and contacts the piezoelectric layer, is adjacent to the second electrode layer along a horizontal direction, and overlap with or partially overlap with the first electrode layer, where the second composite structure includes a second edge extension layer and a second support layer disposed between the piezoelectric layer and the second edge extension layer, where the second support layer is adapted to lower fringe capacitance.

According to some embodiments, the second edge extension layer may be made of a material including a metal.

According to some embodiments, the second support layer may include a medium including one of non-metallic materials, air, and vacuum.

According to some embodiments, the second electrode layer is in a polygonal shape, and the second composite structure is adjacent to at least one side of the second electrode layer.

According to some embodiments, the bulk acoustic wave resonance device further includes a second edge structure, which is disposed at the second side and contacts the piezoelectric layer, and the second edge structure includes a third side and a fourth side opposite to the third side along a horizontal direction, where the second electrode layer is disposed at the third side, and the second composite structure is disposed at the fourth side.

According to some embodiments, the second edge structure may enclose at least part of the second electrode layer.

According to some embodiments, the second electrode layer is disposed at an inner side of the second edge structure, and the second composite structure is disposed at an outer side of the second edge structure.

According to some embodiments, the second edge structure may include a second edge frame layer, which may be made of a material including a metal, and the second edge frame layer is connected to the second electrode layer and further connected to the second edge extension layer.

According to some embodiments, the second edge structure may further include a second edge support layer, which may contact the piezoelectric layer and is disposed between the piezoelectric layer and the second edge frame layer. It should be noted that, the edge support layer may reduce a resonance frequency of a spurious resonance excited due to the edge frame layer, and move the spurious resonance out of a main resonance region.

According to some embodiments, the second edge support layer may include a medium including one of non-metallic materials, air, and vacuum.

According to some embodiments, the second edge structure may include a first overlap with the first electrode layer.

According to some embodiments, the second composite structure may include a second overlap with the first electrode layer, and the second overlap may have a width equal to the width of the second edge structure.

According to some embodiments, the second edge structure is in a polygonal shape, and the second composite structure is adjacent to at least one side of the second edge structure.

According to some embodiments, the second composite structure may further include a second edge part, which includes a fifth side and a sixth side opposite to the fifth side along a horizontal direction, where the second electrode layer is disposed at the fifth side, and the second edge extension layer and the second support layer are disposed at the sixth side.

According to some embodiments, the second edge part may have a thickness equal to a sum of a thickness of the second edge extension layer and a thickness of the second support layer.

According to some embodiments, the second edge part may enclose at least part of the second electrode layer.

According to some embodiments, the second electrode layer is disposed at an inner side of the second edge part, and the second edge extension layer and the second support layer are disposed at an outer side of the second edge part.

According to some embodiments, the second edge part may include a third overlap with the first electrode layer.

According to some embodiments, the second edge extension layer may include a fourth overlap with the second support layer and the first electrode layer, and the fourth overlap may have a width equal to the width of the second edge part.

According to some embodiments, the second edge part is in a polygonal shape, and the second edge extension layer and the second support layer are adjacent to at least one side of the second edge part.

It should be noted that, a composite structure is electrically connected to a second electrode layer or an edge structure corresponding to the second electrode layer, and the composite structure includes an edge extension layer and a compound support layer, and the compound support layer may raise a thickness of dielectric between the edge extension layer and the first electrode layer, thereby lowering fringe capacitance, improving electro-mechanical coupling factor, preventing leaky waves, and raising Q value.

According to some embodiments, the first layer may include an intermediate layer, which includes the cavity and is made of a material including, but not limited to, at least one of polymers, insulating dielectric, and polysilicon.

An embodiment of the present disclosure further provides a filtering device, which includes, but is not limited to, at least one of the bulk acoustic wave resonance devices provided by at least one of the above embodiments.

An embodiment of the present disclosure further provides a radio frequency front-end device, which includes, but is not limited to, a power amplifier device and at least one filtering device provided by the above embodiment, and the power amplifier device is connected to the filtering device.

An embodiment of the present disclosure further provides a radio frequency front-end device, which includes, but is not limited to, a low noise amplifier device and at least one filtering device provided by the above embodiment, and the low noise amplifier device is connected to the filtering device.

An embodiment of the present disclosure further provides a radio frequency front-end device, which includes, but is not limited to, a multiplexing device including at least one filtering device provided by the above embodiment.

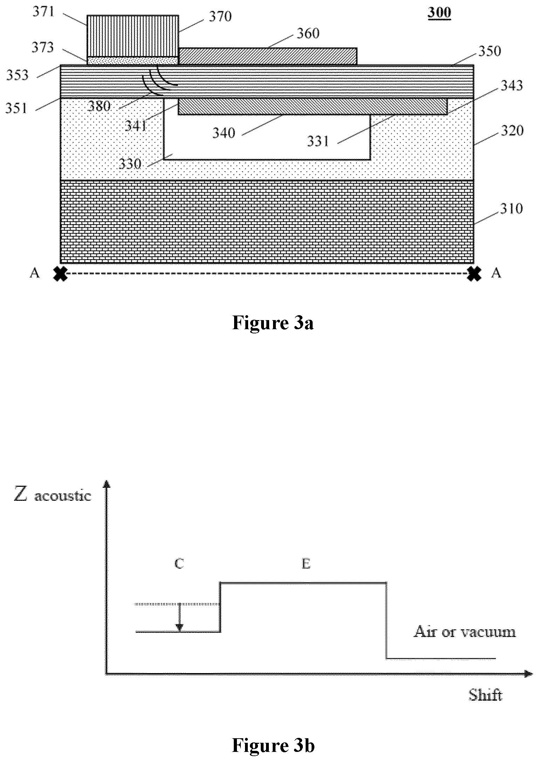

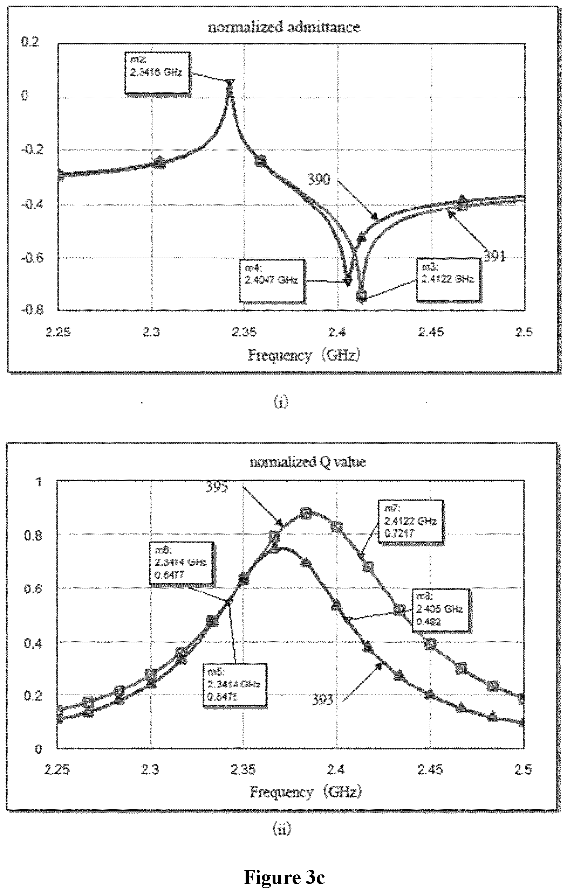

Figures 3 to 14 show specific embodiments of the present disclosure, in which different structures of resonance devices are adopted, nevertheless, the present disclosure may also be implemented in other ways than those described herein, and therefore, the present disclosure is not limited by the specific embodiments disclosed below.

Figure 3a is a schematic structural view of section A of a bulk acoustic wave resonance device 300 according to an embodiment of the present disclosure.

As shown in Figure 3a, an embodiment of the present disclosure provides a bulk acoustic wave resonance device 300, which includes a substrate 310; an intermediate layer 320, which is disposed on the substrate 310 and includes, at an upper surface side of the intermediate layer 320, a cavity 330 and a groove 331, where the groove 331 is disposed at one side of the cavity 330and communicates with the cavity 330, which has a depth less than a depth of the cavity 330; an electrode layer 340, which has a first end 341 disposed in the cavity 330 and a second end 343 disposed in the groove 331, where a thickness of the electrode layer 340 equals to the depth of the groove 331; a piezoelectric layer 350, which is disposed on the electrode layer 340 and the intermediate layer 320and covers the cavity 330,includes a first side 351 and a second side 353 opposite to the first side 351, where the electrode layer 340 and the intermediate layer 320 are disposed at the first side 351; an electrode layer 360, which is disposed at the second side 353 on the piezoelectric layer 350; and a composite structure 370, which is disposed at the second side 353 on the piezoelectric layer 350, is connected to the electrode layer 360, and the composite structure 370 includes an edge extension layer 371 and a compound support layer 373; wherein, the edge extension layer 371 is disposed at the second side 353 above the piezoelectric layer 350 and electrically connected to the electrode layer 360; wherein, the compound support layer 373 is disposed at the second side 353 on the piezoelectric layer 350 and moreover disposed between the piezoelectric layer 350 and the edge extension layer 371, where the compound support layer 373 is connected to the electrode layer 360 and overlaps with the edge extension layer 371.

It should be noted that, the compound support layer 373 may raise a thickness of a medium between the electrode layer 340 and the edge extension layer 371, thereby lowering fringe capacitance 380, and improving electro-mechanical coupling factor of the resonance device to raise passband bandwidth of a filtering device corresponding to the resonance device. In addition, referring to Figure 3b, acoustic impedance difference between region C, where the composite structure 370 is disposed in, and region E, where the electrode layer 360 is disposed in, is greater than that in the case that without composite structure, so that reflectivity of transverse acoustic waves at edges may be improved, and the Q value may be raised. In order to understand this beneficial effect more intuitively, please refer to Figure 3c(i), an admittance curve 390 represents a normalized admittance value of a first BAW resonance device without a composite structure, and an admittance curve 391 represents a normalized admittance value of a second BAW resonance device with a composite structure. A bandwidth between a resonance frequency and an anti-resonance frequency of the admittance curve 391 is greater than a bandwidth between a resonance frequency and an anti-resonance frequency of the admittance curve 390. Please refer to Figure 3c(ii), a quality factor curve 393 represents a normalized Q value of the first BAW resonance device, and a quality factor curve 395 represents a normalized Q value of the second BAW resonance device. It should be noted that, Figure 3c is only schematic, used for more intuitively understanding the beneficial effects of the embodiments of the present disclosure, but is not equivalent to the actual performance of the BAW resonance device according to the embodiments of the present disclosure.

In this embodiment, the substrate 310 may be made of a material including, but not limited to, at least one of silicon, silicon carbide, glass, gallium arsenide, gallium nitride, and ceramic.

In this embodiment, the intermediate layer 320 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 340 may be made of a material including, but not limited to, at least one of molybdenum, ruthenium, tungsten, platinum, iridium, aluminum, and beryllium.

In this embodiment, the piezoelectric layer 350 is a flat layer, and further covers the upper surface side of the intermediate layer 320. In this embodiment, the piezoelectric layer 350 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 350 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system. As shown in Figure 3d, a hexagonal crystal grain, such as a crystal grain of aluminum nitride, may be represented by an ac stereoscopic coordinate system (including a-axis and c-axis). As shown in Figure 3e, crystal grains of (i) orthorhombic system (a≠b≠c), (ii) tetragonal system (a≠b≠c), (iii) cubic system (a=b=c), etc., may be represented by an xyz stereoscopic coordinate system (including x-axis, y-axis, and z-axis). In addition to the above two examples, crystal grains may also be represented based on other known coordinate systems, and therefore the present disclosure is not limited by the above two examples.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 350 includes crystal grains, which form a crystal having a full width at half maximum of rocking curve less than 2.5 degrees. It should be noted that, the rocking curve describes magnitude of angular divergence of a particular crystal plane (a crystal plane determined by a diffraction angle) in a sample, which is represented by a plane coordinate system, and an abscissa is an included angle between the crystal plane and a sample plane, and the ordinate represents a diffraction intensity of the crystal plane at an angle. The rocking curve is used to represent quality of a crystal, and the smaller the full width at half maximum, the better the quality of the crystal. In addition, Full Width at Half Maximum (FWHM) refers to an interval between two points whose function values are equal to a half of a peak value of the function.

It should be noted that, formation of the piezoelectric layer 350 on a plane may allow the piezoelectric layer 350 not to include a crystal grain which suffers from a significant change to its orientation, thereby raising the electro-mechanical coupling factor of the resonance device and the Q value of the resonance device.

In this embodiment, the electrode layer 360 may be made of a material including, but not limited to, at least one of molybdenum, ruthenium, tungsten, platinum, iridium, aluminum, and beryllium.

In this embodiment, the electrode layer 340 has an overlap with the electrode layer 360 that is disposed in the cavity 330; and the electrode layer 360 has an overlap with the electrode layer 340 that is disposed above and corresponding to the cavity 330.

In this embodiment, the edge extension layer 371 may be made of a material including a metal. In this embodiment, the edge extension layer 371 may be made of a material including, but not limited to, at least one of molybdenum, ruthenium, tungsten, platinum, iridium, aluminum, and beryllium.

In this embodiment, the compound support layer 373 may include a medium including a non-metallic material. In this embodiment, the compound support layer 373 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure on a piezoelectric layer may include a medium of vacuum, i.e., a vacuum layer. According to another embodiment, a compound support layer in a composite structure on a piezoelectric layer may include a medium of air, i.e., an air layer.

In this embodiment, the composite structure 370 has no overlap with the electrode layer 340.

Figure 3f is a schematic structural top view of a bulk acoustic wave resonance device 300 according to an embodiment of the present disclosure.

As shown in Figure 3f, in this embodiment, the electrode layer 360 is in an octagonal shape. It should be noted that, known electrode layers of other shapes, such as hexagons, pentagons, etc., may also be applied to the embodiments of the present disclosure. In this embodiment, the composite structure 370 is adjacent to one side of the electrode layer 360.

Figure 4a is a schematic structural view of section A of a bulk acoustic wave resonance device 400 according to an embodiment of the present disclosure.

As shown in Figure 4a, an embodiment of the present disclosure provides a bulk acoustic wave resonance device 400, which includes a substrate 410; an intermediate layer 420, which is disposed on the substrate 410 and includes, at an upper surface side of the intermediate layer 410, a cavity 430 and a groove 431, and the groove 431 is disposed at one side of the cavity 430and communicates with the cavity 430, which has a depth less than a depth of the cavity 430; an electrode layer 440, which is disposed in the cavity 430; a composite structure 450, which has a first end disposed in the cavity 430 and connected to the electrode layer 440 and has a second end opposite to the first end and disposed in the groove 431, where a thickness of the composite structure 450 equals to the depth of the groove 431; wherein, the composite structure 450 includes an edge extension layer 451 and a compound support layer 453, where the edge extension layer 451 is electrically connected to the electrode layer 440, and the compound support layer 453 is disposed on the edge extension layer 371 and connected to the electrode layer 440, and the compound support layer 453 overlaps with the edge extension layer 451; a piezoelectric layer 460, which is disposed on the electrode layer 440, the compound support layer 453 and the intermediate layer 420, covers the cavity 430 and includes a first side 461 and a second side 463 opposite to the first side 461, where the electrode layer 440, the composite structure 450 and the intermediate layer 420 are disposed at the first side 461; and an electrode layer 470, which is disposed at the second side 463 on the piezoelectric layer 460.

It should be noted that, the compound support layer 453 may raise a thickness of a medium between the electrode layer 470 and the edge extension layer 451, thereby lowering fringe capacitance 480, improving electro-mechanical coupling factor of the resonance device, and the composite structure 450 may prevent leaky waves, the Q value may be thus raised.

In this embodiment, the substrate 410 may be made of a material including, but not limited to, at least one of silicon, silicon carbide, glass, gallium arsenide, gallium nitride, and ceramic.

In this embodiment, the intermediate layer 420 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 440 may be made of a material including, but not limited to, at least one of molybdenum, ruthenium, tungsten, platinum, iridium, aluminum, and beryllium.

In this embodiment, the edge extension layer 451 may be made of a material including a metal. In this embodiment, the edge extension layer 451 may be made of a material including, but not limited to, at least one of molybdenum, ruthenium, tungsten, platinum, iridium, aluminum, and beryllium.

In this embodiment, the compound support layer 453 may include a medium including a non-metallic material. In this embodiment, the compound support layer 453 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure under a piezoelectric layer may include a medium of vacuum, i.e., a vacuum layer. According to another embodiment, a compound support layer in a composite structure under a piezoelectric layer may include a medium of air, i.e., an air layer.

In this embodiment, the composite structure 450 has no overlap with the electrode layer 470.

In this embodiment, the piezoelectric layer 460 is a flat layer, and further covers the upper surface side of the intermediate layer 420. In this embodiment, the piezoelectric layer 460 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 460 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 460 includes crystal grains, which form a crystal having a full width at half maximum of rocking curve less than 2.5 degrees.

It should be noted that, formation of the piezoelectric layer 460 on a plane may allow the piezoelectric layer 460 not to include a crystal grain which suffers from a significant change to its orientation, thereby raising the electro-mechanical coupling factor of the resonance device and the Q value of the resonance device.

In this embodiment, the electrode layer 470 may be made of a material including, but not limited to, at least one of molybdenum, ruthenium, tungsten, platinum, iridium, aluminum, and beryllium.

In this embodiment, the electrode layer 440 has an overlap with the electrode layer 470 that is disposed in the cavity 430; and the electrode layer 470 has an overlap with the electrode layer 440 that is disposed above and corresponding to the cavity 430.

Figure 4b is a schematic structural top view of a bulk acoustic wave resonance device 400 according to an embodiment of the present disclosure.

As shown in Figure 4b, in this embodiment, the electrode layer 440 is in an octagonal shape. It should be noted that, known electrode layers of other shapes, such as hexagons, pentagons, etc., may also be applied to the embodiments of the present disclosure. In this embodiment, the composite structure 450 is adjacent to two sides of the electrode layer 440.

Figure 5a is a schematic structural view of section A of a bulk acoustic wave resonance device 500 according to an embodiment of the present disclosure.

As shown in Figure 5a, an embodiment of the present disclosure provides a bulk acoustic wave resonance device 500, which includes a substrate 510; an intermediate layer 520, which is disposed on the substrate 510 and includes, at an upper surface side of the intermediate layer 510, a cavity 530 and a groove 531, and the groove 531 is disposed at one side of the cavity 530and communicates with the cavity 530, which has a depth less than a depth of the cavity 530; an electrode layer 540, which is disposed in the cavity 530; a composite structure 550, which has a first end disposed in the cavity 530 and connected to the electrode layer 540, and has a second end opposite to the first end and disposed in the groove 531, where a thickness of the composite structure 550 equal to the depth of the groove 531; wherein, the composite structure 550 includes an edge extension layer 551 and a compound support layer 553, where the edge extension layer 551 is electrically connected to the electrode layer 540, and the compound support layer 553 is disposed on the edge extension layer 551 and connected to the electrode layer 540, and the compound support layer 553 overlaps with the edge extension layer 551; a piezoelectric layer 560, which is disposed on the electrode layer 540, the compound support layer 553 and the intermediate layer 520 and covers the cavity 530, includes a first side 561 and a second side 563 opposite to the first side 561, where the electrode layer 540, the composite structure 550 and the intermediate layer 520 are disposed at the first side 461; an electrode layer 570, which is disposed at the second side 563 on the piezoelectric layer 560; and a composite structure 580, which is disposed at the second side 563 on the piezoelectric layer 560, is connected to the electrode layer 570; wherein, the composite structure 580 includes an edge extension layer 581 and a compound support layer 583, where the edge extension layer 581 is disposed at the second side 563 above the piezoelectric layer 560 and electrically connected to the electrode layer 570, and the compound support layer 583 is disposed at the second side 563 on the piezoelectric layer 560as well as between the piezoelectric layer 560 and the edge extension layer 581, and the compound support layer 583 is connected to the electrode layer 570 and overlaps with the edge extension layer 581.

It should be noted that, the compound support layer 553 may raise a thickness of a medium between the electrode layer 570 and the edge extension layer 551, where the compound support layer 553 is adapted to lower fringe capacitance 590; and the compound support layer 583 may raise a thickness of a medium between the electrode layer 540 and the edge extension layer 581, where the compound support layer 583 is adapted to lower fringe capacitance 591, thereby electro-mechanical coupling factor of the resonance device may be improved and the composite structure 550 may prevent leaky waves, and the Q value may be thus raised.

In this embodiment, the substrate 510 may be made of a material including, but not limited to, at least one of silicon, silicon carbide, glass, gallium arsenide, gallium nitride, and ceramic.

In this embodiment, the intermediate layer 520 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 540 may be made of a material including, but not limited to, at least one of molybdenum, ruthenium, tungsten, platinum, iridium, aluminum, and beryllium.

In this embodiment, the edge extension layer 551 may be made of a material including a metal. In this embodiment, the edge extension layer 551 may be made of a material including, but not limited to, at least one of molybdenum, ruthenium, tungsten, platinum, iridium, aluminum, and beryllium.

In this embodiment, the compound support layer 553 may include a medium including a non-metallic material. In this embodiment, the compound support layer 553 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure under a piezoelectric layer may include a medium of vacuum, i.e., a vacuum layer. According to another embodiment, a compound support layer in a composite structure under a piezoelectric layer may include a medium of air, i.e., an air layer.

In this embodiment, the piezoelectric layer 560 is a flat layer, and further covers the upper surface side of the intermediate layer 520. In this embodiment, the piezoelectric layer 560 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 560 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 560 includes crystal grains, which form a crystal having a full width at half maximum of rocking curve less than 2.5 degrees.

It should be noted that, formation of the piezoelectric layer 560 on a plane may allow the piezoelectric layer 560 not to include a crystal grain which suffers from a significant change to its orientation, thereby raising the electro-mechanical coupling factor of the resonance device and the Q value of the resonance device.

In this embodiment, the electrode layer 570 may be made of a material including, but not limited to, at least one of molybdenum, ruthenium, tungsten, platinum, iridium, aluminum, and beryllium.

In this embodiment, the electrode layer 540 has an overlap with the electrode layer 570 that is disposed in the cavity 530; and the electrode layer 570 has an overlap with the electrode layer 540 that is disposed above and corresponding to the cavity 530.

In this embodiment, the edge extension layer 581 may be made of a material including a metal. In this embodiment, the edge extension layer 581 may be made of a material including, but not limited to, at least one of molybdenum, ruthenium, tungsten, platinum, iridium, aluminum, and beryllium.

In this embodiment, the compound support layer 583 may include a medium including a non-metallic material. In this embodiment, the compound support layer 583 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure on a piezoelectric layer may include a medium of vacuum, i.e., a vacuum layer. According to another embodiment, a compound support layer in a composite structure on a piezoelectric layer may include a medium of air, i.e., an air layer.

In this embodiment, the composite structure 550 has no overlap with the composite structure 580. In this embodiment, the composite structure 550 and the composite structure 580 are disposed at two sides of an overlap between the electrode layer 540 and electrode layer 570.

Figure 5b is a schematic structural top view of a bulk acoustic wave resonance device 500 according to an embodiment of the present disclosure.

As shown in Figure 5b, in this embodiment, the electrode layer 540 is in an octagonal shape. It should be noted that, known electrode layers of other shapes, such as hexagons, pentagons, etc., may also be applied to the embodiments of the present disclosure. In this embodiment, the composite structure 550 is adjacent to one side of the electrode layer 540. In this embodiment, the electrode layer 570 is in an octagonal shape and overlaps with the electrode layer 540. It should be noted that, known electrode layers of other shapes, such as hexagons, pentagons, etc., may also be applied to the embodiments of the present disclosure. In this embodiment, the composite structure 580 is adjacent to three sides of the electrode layer 570.

Figure 6a is a schematic structural view of section A of a bulk acoustic wave resonance device 600 according to an embodiment of the present disclosure.

As shown in Figure 6a, an embodiment of the present disclosure provides a bulk acoustic wave resonance device 600, which includes a substrate 610; an intermediate layer 620, which is disposed on the substrate 610 and includes, at an upper surface side of the intermediate layer 610, a cavity 630 and a groove 631, and the groove 631 is disposed at one side of the cavity 630and communicates with the cavity 630, which has a depth less than a depth of the cavity 630; an electrode layer 640, which has a first end 641 disposed in the cavity 630 and a second end 643 disposed in the groove 631, where a thickness of the electrode layer 340 equals to the depth of the groove 631; a piezoelectric layer 650, which is disposed on the electrode layer 640 and the intermediate layer 620 and covers the cavity 630, includes a first side 651 and a second side 653 opposite to the first side 651, where the electrode layer 640 and the intermediate layer 620 are disposed at the first side 651; an electrode layer 660, which is disposed at the second side 653 on the piezoelectric layer 650; an edge structure 670, which is disposed at the second side 653 on the piezoelectric layer 650 and has an overlap with the electrode layer 640, and the electrode layer 660 is disposed at an inner side (i.e., a side directing to the central axis of the bulk acoustic wave resonance device 600) of the edge structure 670; and a composite structure 680, which is disposed at the second side 653 on the piezoelectric layer 650 and at an outer side (i.e., a side opposite to the side directing to the central axis of the bulk acoustic wave resonance device 600) of the edge structure 670, is connected to the edge structure 670 and includes an edge extension layer 681 and a compound support layer 683; wherein, the edge extension layer 681 is disposed at the second side 653 above the piezoelectric layer 650 and is electrically connected to the edge structure 670, and the compound support layer 683 is disposed at the second side 653 on the piezoelectric layer 650 and between the piezoelectric layer 650 and the edge extension layer 681, where the compound support layer 683is connected to the edge structure 670 and overlaps with the edge extension layer 681.

It should be noted that, the compound support layer 683 may raise a thickness of a medium between the electrode layer 640 and the edge extension layer 681, where the compound support layer 683 is adapted to lower fringe capacitance between the electrode layer 640 and the edge extension layer 681, and improve electro-mechanical coupling factor of the resonance device. In addition, as shown in Figure 6b, acoustic impedance of region F, where the edge structure 670 is disposed in, is greater than that of region E, where the electrode layer 660 is disposed in; the acoustic impedance of region F is greater than that of air and vacuum; the acoustic impedance of region F is greater than that of region C, where the composite structure 680 is disposed in. Acoustic impedance of region C is less than that of region E. The composite structure 680 may make acoustic impedance of region C closer to acoustic impedance of air or vacuum, so that acoustic waves at the edge of the resonance region may be more effectively reflected, so that leaky waves may be prevented, and the Q value may be improved.

In this embodiment, the substrate 610 may be made of a material including, but not limited to, at least one of silicon, silicon carbide, glass, gallium arsenide, gallium nitride, and ceramic.

In this embodiment, the intermediate layer 620 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 640 may be made of a material including, but not limited to, at least one of molybdenum, ruthenium, tungsten, platinum, iridium, aluminum, and beryllium.

In this embodiment, the piezoelectric layer 650 is a flat layer and further covers the upper surface side of the intermediate layer 620. In this embodiment, the piezoelectric layer 650 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 650 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 650 includes crystal grains, which form a crystal having a full width at half maximum of rocking curve less than 2.5 degrees.

It should be noted that, formation of the piezoelectric layer 650 on a plane may allow the piezoelectric layer 650 not to include a crystal grain which suffers from a significant change to its orientation, thereby raising the electro-mechanical coupling factor of the resonance device and the Q value of the resonance device.

In this embodiment, the electrode layer 660 may be made of a material including, but not limited to, at least one of molybdenum, ruthenium, tungsten, platinum, iridium, aluminum, and beryllium.

In this embodiment, the electrode layer 640 has an overlap with the electrode layer 660 that is disposed in the cavity 630; and the electrode layer 660 has an overlap with the electrode layer 640 that is disposed above and corresponding to the cavity 630.

In this embodiment, the edge structure 670 includes an edge frame layer, which is disposed at the second side 653 above the piezoelectric layer 650 and electrically connected to the electrode layer 660; and an edge support layer, which is disposed at the second side 653 on the piezoelectric layer 650 and between the piezoelectric layer 650 and the edge frame layer, is connected to the electrode layer 660 and overlaps with the edge frame layer.

In this embodiment, the edge frame layer and the edge support layer may be made of different materials. According to another embodiment, an edge frame layer and an edge support layer may be made of the same material.

In this embodiment, the edge frame layer may be made of a material including a metal, and the edge support layer may be made of a material including a non-metallic material. According to another embodiment, an edge frame layer may be made of a material including a metal, and an edge support layer may include a medium including air, i.e., an air layer. According to another embodiment, an edge frame layer may be made of a material including a metal, and an edge support layer may include a medium including vacuum, i.e., a vacuum layer. According to another embodiment, an edge frame layer may be made of a material including a metal, and an edge support layer may be made of a material including a metal.

In this embodiment, the composite structure 680 may have a thickness greater than the thickness of the edge structure 670. According to another embodiment, a composite structure on a piezoelectric layer may have a thickness equal to a thickness of an edge structure on the piezoelectric layer. According to another embodiment, a composite structure on a piezoelectric layer may have a thickness less than a thickness of an edge structure on the piezoelectric layer.

In this embodiment, the edge extension layer 681 may be made of a material including a metal. In this embodiment, the edge extension layer 681 may be made of a material including, but not limited to, at least one of molybdenum, ruthenium, tungsten, platinum, iridium, aluminum, and beryllium.

In this embodiment, the compound support layer 683 may include a medium including a non-metallic material. In this embodiment, the compound support layer 683 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure on a piezoelectric layer may include a medium of vacuum, i.e., a vacuum layer. According to another embodiment, a compound support layer in a composite structure on a piezoelectric layer may include a medium of air, i.e., an air layer.

In this embodiment, the composite structure 680 has no overlap with the electrode layer 640.

Figure 6c is a schematic structural top view of a bulk acoustic wave resonance device 600 according to an embodiment of the present disclosure.

As shown in Figure 6c, in this embodiment, the edge structure 670 is in an annular shape. In this embodiment, the edge structure 670 is in an octagonal shape. It should be noted that, known edge structures of other shapes, such as hexagons, pentagons, etc., may also be applied to the embodiments of the present disclosure. In this embodiment, the composite structure 680 is adjacent to one side of the edge structure 670.

Figure 7a is a schematic structural view of section A of a bulk acoustic wave resonance device 700 according to an embodiment of the present disclosure.

As shown in Figure 7a, an embodiment of the present disclosure provides a bulk acoustic wave resonance device 700, which includes a substrate 710; an intermediate layer 720, which is disposed on the substrate 710 and includes, at an upper surface side of the intermediate layer 710, a cavity 730 and a groove 731, and the groove 731 is disposed at one side of the cavity 730and communicates with the cavity 730, which has a depth less than a depth of the cavity 730; an electrode layer 740, which is disposed in the cavity 730; an edge structure 750, which is disposed in the cavity 730, and the electrode layer 740 is disposed at an inner side (i.e., a side directing to the central axis of the bulk acoustic waves resonance device 700) of the edge structure 750; a composite structure 760, which is disposed at an outer side (i.e., a side opposite to the side directing to the central axis of the bulk acoustic wave resonance device 700) of the edge structure 750, has a first end connected to the edge structure 750 and a second end that is opposite to the first end and disposed in the groove 731, where a thickness of the composite structure 760 equals to the depth of the groove 731;wherein, the composite structure 760 includes an edge extension layer 761 and a compound support layer 763, where the edge extension layer 761 is electrically connected to the edge structure 750, and the compound support layer 763 is disposed on the edge extension layer 761 and is connected to the edge structure 750, and the compound support layer 763 overlaps with the edge extension layer 761; a piezoelectric layer 770, which is disposed on the electrode layer 740, the edge structure 750, the compound support layer 763 and the intermediate layer 720 and covers the cavity 730, includes a first side 771 and a second side 773 opposite to the first side 771, where the electrode layer 740, the edge structure 750, the composite structure 760 and the intermediate layer 720 are disposed at the first side 771; and an electrode layer 780, which is disposed at the second side 773 on the piezoelectric layer 770 and has an overlap with the edge structure 750.

It should be noted that, the compound support layer 763 may raise a thickness of a medium between the electrode layer 780 and the edge extension layer 761, where the first edge support layer is adapted to lower fringe capacitance between the electrode layer 780 and the edge extension layer 761, and improve electro-mechanical coupling factor of the resonance device. In addition, acoustic impedance of an edge region, where the edge structure 750 is disposed in, is greater than that of an inner region, where the electrode layer 740 is disposed in; the acoustic impedance of an edge region is greater than that of air and vacuum; and the acoustic impedance of an edge region is greater than that of an outer region, where the composite structure 760 is disposed in. And, acoustic impedance of the outer region is less than that of the inner region. The composite structure 760 may make acoustic impedance of the outer region closer to acoustic impedance of air and vacuum, so that acoustic waves at the edge of the resonance region may be more effectively reflected, so that leaky waves may be prevented, and the Q value may be improved.

In this embodiment, the substrate 710 may be made of a material including, but not limited to, at least one of silicon, silicon carbide, glass, gallium arsenide, gallium nitride, and ceramic.

In this embodiment, the intermediate layer 720 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 740 may be made of a material including, but not limited to, at least one of molybdenum, ruthenium, tungsten, platinum, iridium, aluminum, and beryllium.

In this embodiment, the edge structure 750 includes an edge frame layer, which is disposed in the cavity 730 and electrically connected to the electrode layer 740; and an edge support layer, which is disposed on the edge frame layer, is connected to the electrode layer 740 and overlaps with the edge frame layer.

In this embodiment, the edge frame layer and the edge support layer may be made of different materials. According to another embodiment, an edge frame layer and an edge support layer may be made of the same material.

In this embodiment, the edge frame layer may be made of a material including a metal, and the edge support layer may be made of a material including a non-metallic material. According to another embodiment, an edge frame layer may be made of a material including a metal, and an edge support layer may include a medium including air, i.e., an air layer. According to another embodiment, an edge frame layer may be made of a material including a metal, and an edge support layer may include a medium including vacuum, i.e., a vacuum layer. According to another embodiment, an edge frame layer may be made of a material including a metal, and an edge support layer may be made of a material including a metal.

In this embodiment, the composite structure 760 may have a thickness greater than a thickness of the edge structure 750. According to another embodiment, a composite structure under a piezoelectric layer may have a thickness equal to a thickness of an edge structure under the piezoelectric layer. According to another embodiment, a composite structure under a piezoelectric layer may have a thickness less than a thickness of an edge structure under the piezoelectric layer.

In this embodiment, the edge extension layer 761 may be made of a material including a metal. In this embodiment, the edge extension layer 761 may be made of a material including, but not limited to, at least one of molybdenum, ruthenium, tungsten, platinum, iridium, aluminum, and beryllium.

In this embodiment, the compound support layer 763 may include a medium including a non-metallic material. In this embodiment, the compound support layer 763 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment,a compound support layer in a composite structure under a piezoelectric layer may include a medium of vacuum, i.e., a vacuum layer. According to another embodiment, a compound support layer in a composite structure under a piezoelectric layer may include a medium of air, i.e., an air layer.

In this embodiment, the composite structure 760 has no overlap with the electrode layer 780.

In this embodiment, the piezoelectric layer 770 is a flat layer and further covers the upper surface side of the intermediate layer 720. In this embodiment, the piezoelectric layer 770 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 770 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 770 includes crystal grains, which form a crystal having a full width at half maximum of rocking curve less than 2.5 degrees.

It should be noted that, formation of the piezoelectric layer 770 on a plane may allow the piezoelectric layer 770 not to include a crystal grain which suffers from a significant change to its orientation, thereby raising the electro-mechanical coupling factor of the resonance device and the Q value of the resonance device.

In this embodiment, the electrode layer 780 may be made of a material including, but not limited to, at least one of molybdenum, ruthenium, tungsten, platinum, iridium, aluminum, and beryllium.

In this embodiment, the electrode layer 740 has an overlap with the electrode layer 780 that is disposed in the cavity 730; and the electrode layer 780 has an overlap with the electrode layer 740 that is disposed above and corresponding to the cavity 730.

Figure 7b is a schematic structural top view of a bulk acoustic wave resonance device 700 according to an embodiment of the present disclosure.

As shown in Figure 7b, in this embodiment, the edge structure 750 is in an annular shape. In this embodiment, the edge structure 750 is in an octagonal shape. It should be noted that, known edge structures of other shapes, such as hexagons, pentagons, etc., may also be applied to the embodiments of the present disclosure. In this embodiment, the composite structure 760 is adjacent to three sides of the edge structure 750.

Figure 8a is a schematic structural view of section A of a bulk acoustic wave resonance device 800 according to an embodiment of the present disclosure.

As shown in Figure 8a, an embodiment of the present disclosure provides a bulk acoustic wave resonance device 800 including: a substrate 810; an intermediate layer 820, which is disposed on the substrate 810 and includes, at an upper surface side of the intermediate layer 820, a cavity 830 and a groove 831, and the groove 831 is disposed at one side of the cavity 830and communicates with the cavity 830, which has a depth less than a depth of the cavity 830; an electrode layer 840, which is disposed in the cavity 830; an edge structure 850, which is disposed in the cavity 830, and the electrode layer 840 is disposed at an inner side (i.e., a side directing to the central axis of the bulk acoustic wave resonance device 800) of the edge structure 850; a composite structure 860, which is disposed at an outer side (i.e., a side opposite to the side directing to the central axis of the bulk acoustic wave resonance device 800) of the edge structure 850, has a first end connected to the edge structure 850 and a second end that is opposite to the first end and disposed in the groove 831, and a thickness of the composite structure 860 equals to the depth of the groove 831; wherein, the composite structure 860 includes an edge extension layer 861 and a compound support layer 863, where the edge extension layer 861 is electrically connected to the edge structure 850, and the compound support layer 863 is disposed on the edge extension layer 861 and is connected to the edge structure 850, and the compound support layer 863 overlaps with the edge extension layer 861; a piezoelectric layer 870, which is disposed on the electrode layer 840, the edge structure 850, the compound support layer 863 and the intermediate layer 820 and covers the cavity 830, includes a first side 871 and a second side 873 opposite to the first side 871, and the electrode layer 840, the edge structure 850, the composite structure 860 and the intermediate layer 820 are disposed at the first side 871; and an electrode layer 880, which is disposed at the second side 873 on the piezoelectric layer 870 and has an overlap with the edge structure 850; an edge structure 851, which is disposed at the second side 873 on the piezoelectric layer 870, has an overlap with the electrode layer 840, and the electrode layer 880 is disposed at an inner side (i.e., a side directing to the central axis of the bulk acoustic wave resonance device 800) of the edge structure 851; and a composite structure 890, which is disposed at the second side 873 on the piezoelectric layer 870 and at an outer side (i.e., a side opposite to the side directing to the central axis of the bulk acoustic wave resonance device 800) of the edge structure 851, is connected to the edge structure 851, and the composite structure 890 includes an edge extension layer 891 and a compound support layer 893; wherein, the edge extension layer 891 is disposed at the second side 873 on the piezoelectric layer 870 and electrically connected to the edge structure 851, and the compound support layer 893 is disposed at the second side 873 on the piezoelectric layer 870 and between the piezoelectric layer 870 and edge extension layer 891, where the compound support layer 893 is connected to the edge structure 851 and overlaps with the edge extension layer 891.

It should be noted that, the compound support layer 863 may raise a thickness of a medium between the electrode layer 880 and the edge extension layer 861, where the compound support layer 863 is adapted to lower fringe capacitance between the electrode layer 880 and the edge extension layer 861, and the compound support layer 893 may raise a thickness of a medium between the electrode layer 840 and the edge extension layer 891, where the compound support layer 893 is adapted to lower fringe capacitance between the electrode layer 840 and the edge extension layer 891, so that electro-mechanical coupling factor of the resonance device may be improved.

In addition, acoustic impedance of a first edge region, where the edge structure 850 is disposed in, is greater than that of an inner region, where the electrode layer 840 is disposed in; the acoustic impedance of the first edge region is greater than that of a first outer region, where the composite structure 860 is disposed in. And, acoustic impedance of the first outer region is less than that of the inner region. The composite structure 860 may make acoustic impedance of the first outer region closer to acoustic impedance of air and vacuum. Moreover, acoustic impedance of a second edge region, where the edge structure 851 is disposed in, is greater than that of an inner region, where the electrode layer 880 is disposed in; the acoustic impedance of the second edge region is greater than that of a second outer region, where the composite structure 890 is disposed in. And, the acoustic impedance of the second outer region is less than that of the inner region. The composite structure 890 may make the acoustic impedance of the second outer region closer to acoustic impedance of air and vacuum. As a result, acoustic waves at the edge of the resonance region may be more effectively reflected, so that leaky waves may be prevented, and the Q value may be improved.

In this embodiment, the substrate 810 may be made of a material including, but not limited to, at least one of silicon, silicon carbide, glass, gallium arsenide, gallium nitride, and ceramic.

In this embodiment, the intermediate layer 820 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 840 may be made of a material including, but not limited to, at least one of molybdenum, ruthenium, tungsten, platinum, iridium, aluminum, and beryllium.

In this embodiment, the edge structure 850 includes a first edge frame layer, which is disposed in the cavity 830 and electrically connected to the electrode layer 840; and a first edge support layer, which is disposed on the first edge frame layer, is connected to the electrode layer 840 and overlaps with the first edge frame layer.

In this embodiment, the first edge frame layer and the first edge support layer may be made of different materials. According to another embodiment, a first edge frame layer and a first edge support layer may be made of the same material.

In this embodiment, the first edge frame layer may be made of a material including a metal, and the first edge support layer may be made of a material including a non-metallic material. According to another embodiment, a first edge frame layer may be made of a material including a metal, and a first edge support layer may include a medium including air, i.e., an air layer. According to another embodiment, a first edge frame layer may be made of a material including a metal, and a first edge support layer may include a medium including vacuum, i.e., a vacuum layer. According to another embodiment, a first edge frame layer may be made of a material including a metal, and a first edge support layer may be made of a material including a metal.

In this embodiment, the composite structure 860 may have a thickness greater than a thickness of the edge structure 850. According to another embodiment, a composite structure under a piezoelectric layer may have a thickness equal to a thickness of an edge structure under the piezoelectric layer. According to another embodiment, a composite structure under a piezoelectric layer may have a thickness less than a thickness of an edge structure under the piezoelectric layer.

In this embodiment, the edge extension layer 861 may be made of a material including a metal. In this embodiment, the edge extension layer 861 may be made of a material including, but not limited to, at least one of molybdenum, ruthenium, tungsten, platinum, iridium, aluminum, and beryllium.

In this embodiment, the compound support layer 863 may include a medium including a non-metallic material. In this embodiment, the compound support layer 863 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure under a piezoelectric layer may include a medium of vacuum, i.e., a vacuum layer. According to another embodiment, a compound support layer in a composite structure under a piezoelectric layer may include a medium of air, i.e., an air layer.

In this embodiment, the composite structure 860 has no overlap with the electrode layer 880.

In this embodiment, the piezoelectric layer 870 is a flat layer and further covers the upper surface side of the intermediate layer 820. In this embodiment, the piezoelectric layer 870 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 870 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 870 includes crystal grains, which form a crystal having a full width at half maximum of rocking curve less than 2.5 degrees.

It should be noted that, formation of the piezoelectric layer 870 on a plane may allow the piezoelectric layer 870 not to include a crystal grain which suffers from a significant change to its orientation, thereby raising the electro-mechanical coupling factor of the resonance device and the Q value of the resonance device.

In this embodiment, the electrode layer 880 may be made of a material including, but not limited to, at least one of molybdenum, ruthenium, tungsten, platinum, iridium, aluminum, and beryllium.

In this embodiment, the electrode layer 840 has an overlap with the electrode layer 880 that is disposed in the cavity 830; and the electrode layer 880 has an overlap with the electrode layer 840 that is disposed above and corresponding to the cavity 830.

In this embodiment, the edge structure 851 includes a second edge frame layer, which is disposed at the second side 873 above the piezoelectric layer 870 and electrically connected to the electrode layer 880; and a second edge support layer, which is disposed at the second side 873 on the piezoelectric layer 870 and between the piezoelectric layer 870 and second edge frame layer, is connected to the electrode layer 880 and overlaps with the second edge frame layer.

In this embodiment, the second edge frame layer and the second edge support layer may be made of different materials. According to another embodiment, a second edge frame layer and a second edge support layer may be made of the same material.

In this embodiment, the second edge frame layer may be made of a material including a metal, and the second edge support layer may be made of a material including a non-metallic material. According to another embodiment, a second edge frame layer may be made of a material including a metal, and a second edge support layer may include a medium including air, i.e., an air layer. According to another embodiment, a second edge frame layer may be made of a material including a metal, and a second edge support layer may include a medium including vacuum, i.e., a vacuum layer. According to another embodiment, a second edge frame layer may be made of a material including a metal, and a second edge support layer may be made of a material including a metal.

In this embodiment, the composite structure 890 may have a thickness greater than a thickness of the edge structure 851. According to another embodiment, a composite structure on a piezoelectric layer may have a thickness equal to a thickness of a edge structure on a piezoelectric layer. According to another embodiment, a composite structure on a piezoelectric layer may have a thickness less than a thickness of an edge structure on a piezoelectric layer.

In this embodiment, the edge extension layer 891 may be made of a material including a metal. In this embodiment, the edge extension layer 891 may be made of a material including, but not limited to, at least one of molybdenum, ruthenium, tungsten, platinum, iridium, aluminum, and beryllium.

In this embodiment, the compound support layer 893 may include a medium including a non-metallic material. In this embodiment, the compound support layer 893 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure on a piezoelectric layer may include a medium of vacuum, i.e., a vacuum layer. According to another embodiment, a compound support layer in a composite structure on a piezoelectric layer may include a medium of air, i.e., an air layer.

In this embodiment, the composite structure 890 has no overlap with the electrode layer 840.

In this embodiment, the composite structure 890 has no overlap with the composite structure 860. In this embodiment, the composite structure 890 and the composite structure 860 are disposed at two sides of the electrode layer 880.

Figure 8b is a schematic structural top view of a bulk acoustic wave resonance device 800 according to an embodiment of the present disclosure.

As shown in Figure 8b, in this embodiment, the edge structure 850 has an overlap 853 with the edge structure 851. In this embodiment, the edge structure 850 and the edge structure 851 form a frame in an annular shape. In this embodiment, the edge structure 850 and the edge structure 851 form a frame in an octagonal shape. It should be noted that, known frames of other shapes, such as, hexagons, pentagons, etc., may also be applied to the embodiments of the present disclosure. In this embodiment, the composite structure 860 is adjacent to two sides of the edge structure 850, and the composite structure 890 is adjacent to the two sides of the edge structure 851.

Figure 9a is a schematic structural view of section A of a bulk acoustic wave resonance device 900 according to an embodiment of the present disclosure.

As shown in Figure 9a, an embodiment of the present disclosure provides a bulk acoustic wave resonance device 900 including: a substrate 910; an intermediate layer 920, which is disposed on the substrate 910 and includes, at an upper surface side of the intermediate layer 920, a cavity 930 and a groove 931, where the groove 931 is disposed at one side of the cavity 930and communicates with the cavity 930, which has a depth less than a depth of the cavity 930; an electrode layer 940, which has a first end 941 disposed in the cavity 930 and a second end 943 disposed in the groove 931, where a thickness of the electrode layer 940 equals to the depth of the groove 931; a piezoelectric layer 950, which is disposed on the electrode layer 940 and on the intermediate layer 920 and covers the cavity 930, includes a first side 951 and a second side 953 opposite to the first side 951, and the electrode layer 940 and the intermediate layer 920 are disposed at the first side 951; an electrode layer 960, which is disposed at the second side 953 on the piezoelectric layer 950; an edge structure 970, which is disposed at the second side 953 on the piezoelectric layer 950 and has an overlap with the electrode layer 940, and the electrode layer 960 is disposed at an inner side (i.e., a side directing to the central axis of the bulk acoustic wave resonance device 900) of the edge structure 970; and a composite structure 980, which is disposed at the second side 953 on the piezoelectric layer 950 and at an outer side (i.e., a side opposite to the side directing to the central axis of the bulk acoustic wave resonance device 900) of the edge structure 970, is connected to the edge structure 970 and includes an edge extension layer 981, a compound support layer 983, an edge extension layer 985 and a compound support layer 987; wherein, the edge extension layer 981 is disposed at the second side 953 over the piezoelectric layer 950 and electrically connected to the edge structure 970; the compound support layer 983 is disposed at the second side 953 on the piezoelectric layer 950 and between the piezoelectric layer 950 and edge extension layer 981, and the compound support layer 983 is connected to the edge structure 970 and overlaps with the edge extension layer 981; the edge extension layer 981 and the compound support layer 983 have a first overlap with the electrode layer 940; the edge extension layer 985 is disposed at the second side 953 over the piezoelectric layer 950 and electrically connected to the edge structure 970; and the compound support layer 987 is disposed at the second side 953 on the piezoelectric layer 950 and between the piezoelectric layer 950, and the edge extension layer 985 is connected to the edge structure 970 and overlaps with the edge extension layer 985; the edge extension layer 985 and the compound support layer 987 have a second overlap with the electrode layer 940.

It should be noted that, the compound support layer 983 may raise a thickness of a medium between the electrode layer 940 and the edge extension layer 981, where the compound support layer 983 is adapted to lower fringe capacitance between the electrode layer 940 and the edge extension layer 981, and the compound support layer 987 may raise a thickness of a medium between the electrode layer 940 and the edge extension layer 985, where the compound support layer 987 is adapted to lower fringe capacitance between the electrode layer 940 and the edge extension layer 985, so that electro-mechanical coupling factor of the resonance device may be improved.

In addition, the edge structure 970 and the composite structure 980 form a reflection structure disposed at an outer side of the electrode layer 960, to reflect acoustic waves in the resonance region, resulting in preventing leaky waves and improving the Q value.

In this embodiment, the substrate 910 may be made of a material including, but not limited to, at least one of silicon, silicon carbide, glass, gallium arsenide, gallium nitride, and ceramic.

In this embodiment, the intermediate layer 920 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 940 may be made of a material including, but not limited to, at least one of molybdenum, ruthenium, tungsten, platinum, iridium, aluminum, and beryllium.

In this embodiment, the piezoelectric layer 950 is a flat layer, and further covers the upper surface side of the intermediate layer 920. In this embodiment, the piezoelectric layer 950 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 950 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 950 includes crystal grains, which form a crystal having a full width at half maximum of rocking curve less than 2.5 degrees.

It should be noted that, formation of the piezoelectric layer 950 on a plane may allow the piezoelectric layer 950 not to include a crystal grain which suffers from a significant change to its orientation, thereby raising the electro-mechanical coupling factor of the resonance device and the Q value of the resonance device.

In this embodiment, the electrode layer 960 may be made of a material including, but not limited to, at least one of molybdenum, ruthenium, tungsten, platinum, iridium, aluminum, and beryllium.

In this embodiment, the electrode layer 940 has an overlap with the electrode layer 960 that is disposed in the cavity 930; and the electrode layer 960 has an overlap with the electrode layer 940 that is disposed above and corresponding to the cavity 930.

In this embodiment, the edge structure 970 includes an edge frame layer, which is disposed at the second side 953 above the piezoelectric layer 950 and electrically connected to the electrode layer 960; and an edge support layer, which is disposed at the second side 953 on the piezoelectric layer 950 and between the piezoelectric layer 950 and the edge frame layer, is connected to the electrode layer 960 and overlaps with the edge frame layer.

In this embodiment, the edge frame layer and the edge support layer may be made of different materials. According to another embodiment, an edge frame layer and an edge support layer may be made of the same material.

In this embodiment, the edge frame layer may be made of a material including a metal, and the edge support layer may be made of a material including a non-metallic material. According to another embodiment, an edge frame layer may be made of a material including a metal, and an edge support layer may include a medium including air, i.e., an air layer. According to another embodiment, an edge frame layer may be made of a material including a metal, and an edge support layer may include a medium including vacuum, i.e., a vacuum layer. According to another embodiment, an edge frame layer may be made of a material including a metal, and an edge support layer may be made of a material including a metal.

In this embodiment, the composite structure 980 may have a thickness greater than the thickness of the edge structure 970. According to another embodiment, a composite structure on a piezoelectric layer may have a thickness equal to a thickness of an edge structure on a piezoelectric layer. According to another embodiment, a composite structure on a piezoelectric layer may have a thickness less than a thickness of an edge structure on a piezoelectric layer.

In this embodiment, the edge extension layer 981 may be made of a material including a metal. In this embodiment, the edge extension layer 981 may be made of a material including, but not limited to, at least one of molybdenum, ruthenium, tungsten, platinum, iridium, aluminum, and beryllium.

In this embodiment, the compound support layer 983 may include a medium including a non-metallic material. In this embodiment, the compound support layer 983 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure on a piezoelectric layer may include a medium of vacuum, i.e., a vacuum layer. According to another embodiment, a compound support layer in a composite structure on a piezoelectric layer may include a medium of air, i.e., an air layer.

In this embodiment, the edge extension layer 985 may be made of a material including a metal. In this embodiment, the edge extension layer 985 may be made of a material including, but not limited to, at least one of molybdenum, ruthenium, tungsten, platinum, iridium, aluminum, and beryllium.

In this embodiment, the compound support layer 987 may include a medium including a non-metallic material. In this embodiment, the compound support layer 987 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure on a piezoelectric layer may include a medium of vacuum, i.e., a vacuum layer. According to another embodiment, a compound support layer in a composite structure on a piezoelectric layer may include a medium of air, i.e., an air layer.

In this embodiment, the edge extension layer 981 has no overlap with the edge extension layer 985. In this embodiment, the edge extension layer 981 and the edge extension layer 985 are disposed at two sides of the electrode layer 960.

In this embodiment, the first overlap has a width equal to the width of the edge structure 970, and the second overlap has a width equal to the width of the edge structure 970.

Figure 9b is a schematic structural top view of a bulk acoustic wave resonance device 900 according to an embodiment of the present disclosure.

As shown in Figure 9b, in this embodiment, the edge structure 970 is in an annular shape. In this embodiment, the edge structure 970 is in an octagonal shape. It should be noted that, known edge structures of other shapes, such as, hexagons, pentagons, etc., may also be applied to the embodiments of the present disclosure. In this embodiment, the composite structure 980 is adjacent to two sides of the edge structure 970, and the edge extension layer 981 is adjacent to a first side, the edge extension layer 985 is adjacent to a second side, and the first side and the second side are respectively disposed at two ends of the electrode layer 960.

Figure 10a is a schematic structural view of section A of a bulk acoustic wave resonance device 1000 according to an embodiment of the present disclosure.

As shown in Figure 10a, an embodiment of the present disclosure provides a bulk acoustic wave resonance device 1000 including: a substrate 1010; an intermediate layer 1020, which is disposed on the substrate 1010 and includes, at an upper surface side of the intermediate layer 1020, a cavity 1030 and a groove 1031, and the groove 1031 is disposed at one side of the cavity 1030and communicates with the cavity 1030, which has a depth less than a depth of the cavity 1030; an electrode layer 1040, which is disposed in the cavity 1030; an edge structure 1050, which is disposed in the cavity 1030, and the electrode layer 1040 is disposed at an inner side (i.e., a side directing to the central axis of the bulk acoustic wave resonance device 1000) of the edge structure 1050; a composite structure 1060, which is disposed at an outer side (i.e., a side opposite to the side directing to the central axis of the bulk acoustic wave resonance device 1000) of the edge structure 1050, has a first end disposed in the cavity 1030 and a second end opposite to the first end and disposed in the groove 1031 where a thickness of the electrode layer 340 equals to the depth of the groove 1031; wherein, the composite structure 1060 includes an edge extension layer 1061, a compound support layer 1063, an edge extension layer 1065 and a compound support layer 1067; the edge extension layer 1061 is electrically connected to the edge structure 1050; the compound support layer 1063 is disposed on the edge extension layer 1061, and connected to the edge structure 1050, and the compound support layer 1063 overlaps with the edge extension layer 1061; the edge extension layer 1065 is disposed in the cavity 1030 and electrically connected to the edge structure 1050; and the compound support layer 1067, which is disposed in the cavity 1030 and on the edge extension layer 1065, , is connected to the edge structure 1050 and overlaps with the edge extension layer 1065; a piezoelectric layer 1070, which is disposed on the electrode layer 1040, the edge structure 1050, the compound support layer 1063, the compound support layer 1067 and the intermediate layer 1020 and covers the cavity 1030, includes a first side 1071 and a second side 1073 opposite to the first side 1071, where the electrode layer 1040, the edge structure 1050, the composite structure 1060 and the intermediate layer 1020 are disposed at the first side 1071; an electrode layer 1080, which is disposed at the second side 1073 on the piezoelectric layer 1070, has an overlap with the edge structure 1050, where the electrode layer 1080 has a first overlap with edge extension layer 1061 and the compound support layer 1063 and has a second overlap with the edge extension layer 1065 and the compound support layer 1067.

It should be noted that, the compound support layer 1063 may raise a thickness of a medium between the electrode layer 1080 and the edge extension layer 1061, where the compound support layer 1063 is adapted to lower fringe capacitance between the electrode layer 1080 and the edge extension layer 1061, and the compound support layer 1067 may raise a thickness of a medium between the electrode layer 1080 and the edge extension layer 1065, where the compound support layer 1067 is adapted to lower fringe capacitance between the electrode layer 1080 and the edge extension layer 1065, so that electro-mechanical coupling factor of the resonance device may be improved.

In addition, the edge structure 1050 and the composite structure 1060 form a reflection structure disposed at an outer side of the electrode layer 1040, to reflect acoustic waves in the resonance region, resulting in preventing leaky waves and improving the Q value.

In this embodiment, the substrate 1010 may be made of a material including, but not limited to, at least one of silicon, silicon carbide, glass, gallium arsenide, gallium nitride, and ceramic.

In this embodiment, the intermediate layer 1020 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 1040 may be made of a material including, but not limited to, at least one of molybdenum, ruthenium, tungsten, platinum, iridium, aluminum, and beryllium.

In this embodiment, the edge structure 1050 includes an edge frame layer, which is disposed in the cavity 1030 and electrically connected to the electrode layer 1040; and an edge support layer, which is disposed in the cavity 1030 and on the edge frame layer, is connected to the electrode layer 1040 and overlaps with the edge frame layer.

In this embodiment, the edge frame layer and the edge support layer may be made of different materials. According to another embodiment, an edge frame layer and an edge support layer may be made of the same material.

In this embodiment, the edge frame layer may be made of a material including a metal, and the edge support layer may be made of a material including a non-metallic material. According to another embodiment, an edge frame layer may be made of a material including a metal, and an edge support layer may include a medium including air, i.e., an air layer. According to another embodiment, an edge frame layer may be made of a material including a metal, and an edge support layer may include a medium including vacuum, i.e., a vacuum layer. According to another embodiment, an edge frame layer may be made of a material including a metal, and an edge support layer may be made of a material including a metal.

In this embodiment, the composite structure 1060 may have a thickness greater than the thickness of the edge structure 1050. According to another embodiment, a composite structure under a piezoelectric layer may have a thickness equal to a thickness of an edge structure under the piezoelectric layer. According to another embodiment, a composite structure under a piezoelectric layer may have a thickness less than a thickness of an edge structure under the piezoelectric layer.

In this embodiment, the edge extension layer 1061 may be made of a material including a metal. In this embodiment, the edge extension layer 1061 may be made of a material including, but not limited to, at least one of molybdenum, ruthenium, tungsten, platinum, iridium, aluminum, and beryllium.

In this embodiment, the compound support layer 1063 may include a medium including a non-metallic material. In this embodiment, the compound support layer 1063 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a first compound support layer in a composite structure under a piezoelectric layer may include a medium of vacuum, i.e., a vacuum layer. According to another embodiment, a first compound support layer in a composite structure under a piezoelectric layer may include a medium of air, i.e., an air layer.

In this embodiment, the edge extension layer 1065 may be made of a material including a metal. In this embodiment, the edge extension layer 1065 may be made of a material including, but not limited to, at least one of molybdenum, ruthenium, tungsten, platinum, iridium, aluminum, and beryllium.

In this embodiment, the compound support layer 1067 may include a medium including a non-metallic material. In this embodiment, the compound support layer 1067 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a second compound support layer in a composite structure under a piezoelectric layer may include a medium of vacuum, i.e., a vacuum layer. According to another embodiment, a second compound support layer in a composite structure under a piezoelectric layer may include a medium of air, i.e., an air layer.

In this embodiment, the edge extension layer 1061 has no overlap with the edge extension layer 1065. In this embodiment, the edge extension layer 1061 and the edge extension layer 1065 are disposed at two sides of the electrode layer 1040.

In this embodiment, the piezoelectric layer 1070 is a flat layer, and further covers the upper surface side of the intermediate layer 1020. In this embodiment, the piezoelectric layer 1070 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 1070 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 1070 includes crystal grains, which form a crystal having a full width at half maximum of rocking curve less than 2.5 degrees.

It should be noted that, formation of the piezoelectric layer 1070 on a plane may allow the piezoelectric layer 1070 not to include a crystal grain which suffers from a significant change to its orientation, thereby raising the electro-mechanical coupling factor of the resonance device and the Q value of the resonance device.

In this embodiment, the electrode layer 1080 may be made of a material including, but not limited to, at least one of molybdenum, ruthenium, tungsten, platinum, iridium, aluminum, and beryllium.

In this embodiment, the electrode layer 1040 has an overlap with the electrode layer 1080 that is disposed in the cavity 1030; and the electrode layer 1080 has an overlap with the electrode layer 1040 that is disposed above and corresponding to the cavity 1030.

In this embodiment, the first overlap has a width equal to a width of the edge structure 1050, and the second overlap has a width equal to a width of the edge structure 1050.

Figure 10b is a schematic structural top view of a bulk acoustic wave resonance device 1000 according to an embodiment of the present disclosure.

As shown in Figure 10b, in this embodiment, the edge structure 1050 is in an annular shape. In this embodiment, the edge structure 1050 is in an octagonal shape. It should be noted that, known edge structures of other shapes, such as, hexagons, pentagons, etc., may also be applied to the embodiments of the present disclosure. In this embodiment, the composite structure 1060 is adjacent to four sides of the edge structure 1050, and the edge extension layer 1061 is adjacent to a first side and a second side, the edge extension layer 1065 is adjacent to a third side and a fourth side, the first side and the second side are disposed at a first end of the electrode layer 1040, and the third side and the fourth side are disposed at a second end of the electrode layer 1040.

Figure 11a is a schematic structural view of section A of a bulk acoustic wave resonance device 1100 according to an embodiment of the present disclosure.

As shown in Figure 11a, an embodiment of the present disclosure provides a bulk acoustic wave resonance device 1100 including: a substrate 1110; an intermediate layer 1120, which is disposed on the substrate 1110 and includes, at an upper surface side of the intermediate layer 1120, a cavity 1130 and a groove 1131, and the groove 1131 is disposed at one side of the cavity 1130and communicates with the cavity 1130, which has a depth less than a depth of the cavity 1130; an electrode layer 1140, which is disposed in the cavity 1130; an edge structure 1150, which is disposed in the cavity 1130, and the electrode layer 1140 is disposed at an inner side (i.e., a side directing to the central axis of the bulk acoustic wave resonance device 1100) of the edge structure 1150; a composite structure 1160, which is disposed at an outer side (i.e., a side opposite to the side directing to the central axis of the bulk acoustic wave resonance device 1100) of the edge structure 1150, has a first end connected to the edge structure 1150 and a second end that is opposite to the first end and disposed in the groove 1131, where a thickness of the composite structure 1160 equals to the depth of the groove 1131; wherein, the composite structure 1160 includes an edge extension layer 1161 and a compound support layer 1163, where the edge extension layer 1161 is electrically connected to the edge structure 1150, and the compound support layer 1163 is disposed on the edge extension layer 1161 and connected to the edge structure 1150, and the compound support layer 1163 overlaps with the edge extension layer 1161; a piezoelectric layer 1170, which is disposed on the electrode layer 1140, the edge structure 1150, the compound support layer 1163 and the intermediate layer 1120 and covers the cavity 1130, includes a first side 1171 and a second side 1173 opposite to the first side 1171, where the electrode layer 1140, the edge structure 1150, the composite structure 1160 and the intermediate layer 1120 are disposed at the first side 1171; an electrode layer 1180, which is disposed at the second side 1173 on the piezoelectric layer 1170, has an overlap with the edge structure 1150, where the electrode layer 1180 has a first overlap with the edge extension layer 1161 and the compound support layer 1163; an edge structure 1151, which is disposed at the second side 1173 on the piezoelectric layer 1170, has an overlap with the electrode layer 1140, and the electrode layer 1180 is disposed at an inner side of the edge structure 1151; and a composite structure 1190, which is disposed at the second side 1173 on the piezoelectric layer 1170 and at an outer side of the edge structure 1151, is connected to the edge structure 1151, and includes an edge extension layer 1191 and a compound support layer 1193; wherein the edge extension layer 1191 is disposed at the second side 1173 over the piezoelectric layer 1170 and electrically connected to the edge structure 1151, and the compound support layer 1193 is disposed at the second side 1173 on the piezoelectric layer 1170 and between the piezoelectric layer 1170 and edge extension layer 1191, and the compound support layer 1193 is connected to the edge structure 1151 and overlaps with the edge extension layer 1191, where the edge extension layer 1191 and the compound support layer 1193 have a second overlap with the electrode layer 1140.

It should be noted that, the compound support layer 1163 may raise a thickness of a medium between the electrode layer 1180 and the edge extension layer 1161, where the compound support layer 1163 is adapted to lower fringe capacitance between the electrode layer 1180 and the edge extension layer 1161, and the compound support layer 1193 may raise a thickness of a medium between the electrode layer 1140 and the edge extension layer 1191, where the compound support layer 1193 is adapted to lower fringe capacitance between the electrode layer 1140 and the edge extension layer 1191, so that electro-mechanical coupling factor of the resonance device may be improved.

In addition, the edge structure 1150 and the composite structure 1160 form a first reflection structure disposed at an outer side of the electrode layer 1140, and the edge structure 1151 and the composite structure 1190 form a second reflection structure disposed at an outer side of the electrode layer 1180, to reflect acoustic waves in the resonance region, resulting in preventing leaky waves and improving the Q value.

In this embodiment, the substrate 1110 may be made of a material including, but not limited to, at least one of silicon, silicon carbide, glass, gallium arsenide, gallium nitride, and ceramic.

In this embodiment, the intermediate layer 1120 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 1140 may be made of a material including, but not limited to, at least one of molybdenum, ruthenium, tungsten, platinum, iridium, aluminum, and beryllium.

In this embodiment, the edge structure 1150 includes a first edge frame layer, which is disposed in the cavity 1130 and electrically connected to the electrode layer 1140; and a first edge support layer, which is disposed on the first edge frame layer in the cavity 1130, is connected to the electrode layer 1140 and overlaps with the first edge frame layer.

In this embodiment, the first edge frame layer and the first edge support layer may be made of different materials. According to another embodiment, a first edge frame layer and a first edge support layer may be made of the same material.

In this embodiment, the first edge frame layer may be made of a material including a metal, and the first edge support layer may be made of a material including a non-metallic material. According to another embodiment, a first edge frame layer may be made of a material including a metal, and a first edge support layer may include a medium including air, i.e., an air layer. According to another embodiment, a first edge frame layer may be made of a material including a metal, and a first edge support layer may include a medium including vacuum, i.e., a vacuum layer. According to another embodiment, a first edge frame layer may be made of a material including a metal, and a first edge support layer may be made of a material including a metal.

In this embodiment, the composite structure 1160 may have a thickness greater than a thickness of the edge structure 1150. According to another embodiment, a composite structure under a piezoelectric layer may have a thickness equal to a thickness of an edge structure under a piezoelectric layer. According to another embodiment, a composite structure under a piezoelectric layer may have a thickness less than a thickness of an edge structure under a piezoelectric layer.

In this embodiment, the edge extension layer 1161 may be made of a material including a metal. In this embodiment, the edge extension layer 1161 may be made of a material including, but not limited to, at least one of molybdenum, ruthenium, tungsten, platinum, iridium, aluminum, and beryllium.

In this embodiment, the compound support layer 1163 may include a medium including a non-metallic material. In this embodiment, the compound support layer 1163 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure under a piezoelectric layer may include a medium of vacuum, i.e., a vacuum layer. According to another embodiment, a compound support layer in a composite structure under a piezoelectric layer may include a medium of air, i.e., an air layer.

In this embodiment, the piezoelectric layer 1170 is a flat layer and further covers the upper surface side of the intermediate layer 1120. In this embodiment, the piezoelectric layer 1170 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 1170 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 1170 includes crystal grains, which form a crystal having a full width at half maximum of rocking curve less than 2.5 degrees.

It should be noted that, formation of the piezoelectric layer 1170 on a plane may allow the piezoelectric layer 1170 not to include a crystal grain which suffers from a significant change to its orientation, thereby raising the electro-mechanical coupling factor of the resonance device and the Q value of the resonance device.

In this embodiment, the electrode layer 1180 may be made of a material including, but not limited to, at least one of molybdenum, ruthenium, tungsten, platinum, iridium, aluminum, and beryllium.

In this embodiment, the electrode layer 1140 has an overlap with the electrode layer 1180 that is disposed in the cavity 1130; and the electrode layer 1180 has an overlap with the electrode layer 1140 that is disposed above and corresponding to the cavity 1130.

In this embodiment, the edge structure 1151 includes a second edge frame layer, which is disposed at the second side 1173 above the piezoelectric layer 1170 and electrically connected to the electrode layer 1180; and a second edge support layer, which is disposed at the second side 1173 on the piezoelectric layer 1170 and between the piezoelectric layer 1170 and second edge frame layer, is connected to the electrode layer 1180 and overlaps with the second edge frame layer.

In this embodiment, the second edge frame layer and the second edge support layer may be made of different materials. According to another embodiment, a second edge frame layer and a second edge support layer may be made of the same material.

In this embodiment, the second edge frame layer may be made of a material including a metal, and the second edge support layer may be made of a material including a non-metallic material. According to another embodiment, a second edge frame layer may be made of a material including a metal, and a second edge support layer may include a medium including air, i.e., an air layer. According to another embodiment, a second edge frame layer may be made of a material including a metal, and a second edge support layer may include a medium including vacuum, i.e., a vacuum layer. According to another embodiment, a second edge frame layer may be made of a material including a metal, and a second edge support layer may be made of a material including a metal.

In this embodiment, the composite structure 1190 may have a thickness greater than a thickness of the edge structure 1151. According to another embodiment, a composite structure on a piezoelectric layer may have a thickness equal to a thickness of an edge structure on a piezoelectric layer. According to another embodiment, a composite structure on a piezoelectric layer may have a thickness less than a thickness of an edge structure on a piezoelectric layer.

In this embodiment, the edge extension layer 1191 may be made of a material including a metal. In this embodiment, the edge extension layer 1191 may be made of a material including, but not limited to, at least one of molybdenum, ruthenium, tungsten, platinum, iridium, aluminum, and beryllium.

In this embodiment, the compound support layer 1193 may include a medium including a non-metallic material. In this embodiment, the compound support layer 1193 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a compound support layer in a composite structure on a piezoelectric layer may include a medium of vacuum, i.e., a vacuum layer. According to another embodiment, a compound support layer in a composite structure on a piezoelectric layer may include a medium of air, i.e., an air layer.

In this embodiment, the composite structure 1160 has no overlap with the composite structure 1190. In this embodiment, the composite structure 1160 and the composite structure 1190 are disposed at two sides of the electrode layer 1140.

In this embodiment, the first overlap has a width equal to a width of the edge structure 1150, and the second overlap has a width equal to a width of the edge structure 1151.

Figure 11b is a schematic structural top view of a bulk acoustic wave resonance device 1100 according to an embodiment of the present disclosure.

As shown in Figure 11b, in this embodiment, the edge structure 1150 and the edge structure 1151 overlaps partially and form a frame structure. In this embodiment, the frame structure is in an octagonal shape. It should be noted that, known frame structures of other shapes, such as hexagons, pentagons, etc., may also be applied to the embodiments of the present disclosure. In this embodiment, the composite structure 1160 is adjacent to one side of the edge structure 1150, and the composite structure 1190 is adjacent to one side of the edge structure 1151.

Figure 12a is a schematic structural view of section A of a bulk acoustic wave resonance device 1200 according to an embodiment of the present disclosure.

As shown in Figure 12a, an embodiment of the present disclosure provides a bulk acoustic wave resonance device 1200 including: a substrate 1210; an intermediate layer 1220, which is disposed on the substrate 1210 and includes, at an upper surface side of the intermediate layer 1220, a cavity 1230 and a groove 1231, and the groove 1231 is disposed at one side of the cavity 1230and communicates with the cavity 1230, which has a depth less than a depth of the cavity 1230; an electrode layer 1240, which has a first end 1241 disposed in the cavity 1230 and a second end 1243 disposed in the groove 1231, where a thickness of the electrode layer 340 equals to the depth of the groove 1231; a piezoelectric layer 1250, which is disposed on the electrode layer 1240 and on the intermediate layer 1220 and covers the cavity 1230, includes a first side 1251 and a second side 1253 opposite to the first side 1251, where the electrode layer 1240 and the intermediate layer 1220 are disposed at the first side 1251; an electrode layer 1260, which is disposed at the second side 1253 on the piezoelectric layer 1250; and a composite structure 1270 including: an edge part 1271 that is disposed at the second side 1253 on the piezoelectric layer 1250 and has an overlap with the electrode layer 1240, where the electrode layer 1260 is disposed at an inner side (i.e., a side directing to the central axis of the bulk acoustic wave resonance device 1200) of the edge part 1271; an extension part (not marked), which is disposed at the second side 1253 on the piezoelectric layer 1250 and at an outer side (i.e., a side opposite to the side directing to the central axis of the bulk acoustic wave resonance device 1200) of the edge part 1271, is connected to the edge part 1271, where the extension part includes an edge extension layer 1273, a compound support layer 1275, an edge extension layer 1277 and a compound support layer 1279; wherein, the edge extension layer 1273 is disposed at the second side 1253 over the piezoelectric layer 1250 and electrically connected to the edge part 1271; the compound support layer 1275 is disposed at the second side 1253 on the piezoelectric layer 1250 and between the piezoelectric layer 1250 and edge extension layer 1273, and the compound support layer 1275 is connected to the edge part 1271 and overlaps with the edge extension layer 1273, where the edge extension layer 1273 and the compound support layer 1275 have a first overlap with the electrode layer 1240; the edge extension layer 1277 is disposed at the second side 1253 over the piezoelectric layer 1250 and electrically connected to the edge part 1271; and the compound support layer 1279 is disposed at the second side 1253 on the piezoelectric layer 1250 and between the piezoelectric layer 1250 and edge extension layer 1277, and the compound support layer 1279 is connected to the edge part 1271 and overlaps with the edge extension layer 1277, where the edge extension layer 1277 and the compound support layer 1279 have a second overlap with the electrode layer 1240.

It should be noted that, the compound support layer 1275 may raise a thickness of a medium between the electrode layer 1240 and the edge extension layer 1273, where the compound support layer 1275 is adapted to lower fringe capacitance between the electrode layer 1240 and the edge extension layer 1273, and the compound support layer 1279 may raise a thickness of a medium between the electrode layer 1240 and the edge extension layer 1277, where the compound support layer 1279 is adapted to lower fringe capacitance between the electrode layer 1240 and the edge extension layer 1277, so that electro-mechanical coupling factor of the resonance device may be improved.

In addition, the edge part 1271 and the extension part form a reflection structure disposed at an outer side of the electrode layer 1260, to reflect acoustic waves in the resonance region, resulting in preventing leaky waves and improving the Q value.

In this embodiment, the substrate 1210 may be made of a material including, but not limited to, at least one of silicon, silicon carbide, glass, gallium arsenide, gallium nitride, and ceramic.

In this embodiment, the intermediate layer 1220 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 1240 may be made of a material including, but not limited to, at least one of molybdenum, ruthenium, tungsten, platinum, iridium, aluminum, and beryllium.

In this embodiment, the piezoelectric layer 1250 is a flat layer, and further covers the upper surface side of the intermediate layer 1220. In this embodiment, the piezoelectric layer 1250 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 1250 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 1250 includes crystal grains, which form a crystal having a full width at half maximum of rocking curve less than 2.5 degrees.

It should be noted that, formation of the piezoelectric layer 1250 on a plane may allow the piezoelectric layer 1250 not to include a crystal grain which suffers from a significant change to its orientation, thereby raising the electro-mechanical coupling factor of the resonance device and the Q value of the resonance device.

In this embodiment, the electrode layer 1260 may be made of a material including, but not limited to, at least one of molybdenum, ruthenium, tungsten, platinum, iridium, aluminum, and beryllium.

In this embodiment, the electrode layer 1240 has an overlap with the electrode layer 1260 that is disposed in the cavity 1230; and the electrode layer 1260 has an overlap with the electrode layer 1240 that is disposed above and corresponding to the cavity 1230.

In this embodiment, the edge part 1271 includes an edge frame layer, which is disposed at the second side 1253 above the piezoelectric layer 1250 and electrically connected to the electrode layer 1260; and an edge support layer, which is disposed at the second side 1253 on the piezoelectric layer 1250 and between the piezoelectric layer 1250 and the edge frame layer, is connected to the electrode layer 1260 and overlaps with the edge frame layer.

In this embodiment, the edge frame layer and the edge support layer may be made of different materials. According to another embodiment, an edge frame layer and an edge support layer may be made of the same material.

In this embodiment, the edge frame layer may be made of a material including a metal, and the edge support layer may be made of a material including a non-metallic material. According to another embodiment, an edge frame layer may be made of a material including a metal, and an edge support layer may include a medium including air, i.e., an air layer. According to another embodiment, an edge frame layer may be made of a material including a metal, and an edge support layer may include a medium including vacuum, i.e., a vacuum layer. According to another embodiment, an edge frame layer may be made of a material including a metal, and an edge support layer may be made of a material including a metal.

In this embodiment, the extension part may have a thickness equal to a thickness of the edge part 1271.

In this embodiment, the edge extension layer 1273 may be made of a material including a metal. In this embodiment, the edge extension layer 1273 may be made of a material including, but not limited to, at least one of molybdenum, ruthenium, tungsten, platinum, iridium, aluminum, and beryllium.

In this embodiment, the compound support layer 1275 may include a medium including a non-metallic material. In this embodiment, the compound support layer 1275 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a first compound support layer of an extension part on a piezoelectric layer may include a medium of vacuum, i.e., a vacuum layer. According to another embodiment, a first compound support layer of an extension part on a piezoelectric layer may include a medium of air, i.e., an air layer.

In this embodiment, the compound support layer 1275 may have a thickness greater than a thickness of the edge support layer. According to another embodiment, a first compound support layer of an extension part may have a thickness equal to a thickness of an edge support layer of an edge part. According to another embodiment, a first compound support layer of an extension part may have a thickness less than a thickness of an edge support layer of an edge part.

In this embodiment, the edge extension layer 1277 may be made of a material including a metal. In this embodiment, the edge extension layer 1277 may be made of a material including, but not limited to, at least one of molybdenum, ruthenium, tungsten, platinum, iridium, aluminum, and beryllium.

In this embodiment, the compound support layer 1279 may include a medium including a non-metallic material. In this embodiment, the compound support layer 1279 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a second compound support layer of an extension part on a piezoelectric layer may include a medium of vacuum, i.e., a vacuum layer. According to another embodiment, a second compound support layer of an extension part on a piezoelectric layer may include a medium of air, i.e., an air layer.

In this embodiment, the compound support layer 1279 may have a thickness greater than a thickness of the edge support layer. According to another embodiment, a second compound support layer of an extension part may have a thickness equal to a thickness of an edge support layer of an edge part. According to another embodiment, a second compound support layer of an extension part may have a thickness less than a thickness of an edge support layer of an edge part.

In this embodiment, the edge extension layer 1273 has no overlap with the edge extension layer 1277. In this embodiment, the edge extension layer 1273 and the edge extension layer 1277 are disposed at two sides of the electrode layer 1260.

In this embodiment, the first overlap has a width equal to a width of the edge part 1271, and the second overlap has a width equal to a width of the edge part 1271.

Figure 12b is a schematic structural top view of a bulk acoustic wave resonance device 1200 according to an embodiment of the present disclosure.

As shown in Figure 12b, in this embodiment, the edge part 1271 is in an annular shape. In this embodiment, the edge part 1271 is in an octagonal shape. It should be noted that, known edge parts of other shapes, such as, hexagons, pentagons, etc., may also be applied to the embodiments of the present disclosure. In this embodiment, the extension part is adjacent to two sides of the edge part 1271, and the edge extension layer 1273 is adjacent to a first side, the edge extension layer 1277 is adjacent to a second side, and the first side and the second side are respectively disposed at two ends of the electrode layer 1260.

Figure 13a is a schematic structural view of section A of a bulk acoustic wave resonance device 1300 according to an embodiment of the present disclosure.

As shown in Figure 13a, an embodiment of the present disclosure provides a bulk acoustic wave resonance device 1300 including: a substrate 1310; an intermediate layer 1320, which is disposed on the substrate 1310 and includes, at an upper surface side of the intermediate layer 1320, a cavity 1330 and a groove 1331, and the groove 1331 is disposed at one side of the cavity 1330and communicates with the cavity 1330, which has a depth less than a depth of the cavity 1330; an electrode layer 1340, which is disposed in the cavity 1330; a composite structure 1350 including: an edge part 1351 that is disposed in the cavity 1330, where the electrode layer 1340 is disposed at an inner side (i.e., a side directing to the central axis of the bulk acoustic wave resonance device 1300) of the edge part 1351; an extension part (not marked), which has a first end disposed in the cavity 1330 and a second end opposite to the first end and disposed in the groove 1331, has a thickness equal to the depth of the groove 1331 and is disposed at an outer side (i.e., a side opposite to the side directing to the central axis of the bulk acoustic wave resonance device 1300) of the edge part 1351, and the extension part includes an edge extension layer 1353, a compound support layer 1355, an edge extension layer 1357 and a compound support layer 1359; wherein, the edge extension layer 1353 is electrically connected to the edge part 1351; the compound support layer 1355 is disposed on the edge extension layer 1353, and is connected to the edge part 1351, where the compound support layer 1355 overlaps with the edge extension layer 1353; the edge extension layer 1357 is disposed in the cavity 1330 and electrically connected to the edge part 1351; and the compound support layer 1359 is disposed on the edge extension layer 1357 in the cavity 1330 and is connected to the edge part 1351, where the compound support layer 1359 overlaps with the edge extension layer 1357; a piezoelectric layer 1360, which is disposed on the electrode layer 1340, the edge part 1351, the compound support layer 1355, the compound support layer 1359 and the intermediate layer 1320 and covers the cavity 1330, includes a first side 1361 and a second side 1363 opposite to the first side 1361, where the electrode layer 1340, the composite structure 1350 and the intermediate layer 1320 are disposed at the first side 1361; an electrode layer 1370, which is disposed at the second side 1363 on the piezoelectric layer 1360, has an overlap with the edge part 1351, where the electrode layer 1370 has a first overlap with the edge extension layer 1353 and the compound support layer 1355 and has a second overlap with the edge extension layer 1357 and the compound support layer 1359.

It should be noted that, the compound support layer 1355 may raise a thickness of a medium between the electrode layer 1370 and the edge extension layer 1353, where the compound support layer 1355 is adapted to lower fringe capacitance between the electrode layer 1370 and the edge extension layer 1353, and the compound support layer 1359 may raise a thickness of a medium between the electrode layer 1370 and the edge extension layer 1357, where the compound support layer 1359 is adapted to lower fringe capacitance between the electrode layer 1370 and the edge extension layer 1357, so that electro-mechanical coupling factor of the resonance device may be improved.

In addition, the edge part 1351 and the extension part form a reflection structure disposed at an outer side of the electrode layer 1340, to reflect acoustic waves in the resonance region, resulting in preventing leaky waves and improving the Q value.

In this embodiment, the substrate 1310 may be made of a material including, but not limited to, at least one of silicon, silicon carbide, glass, gallium arsenide, gallium nitride, and ceramic.

In this embodiment, the intermediate layer 1320 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 1340 may be made of a material including, but not limited to, at least one of molybdenum, ruthenium, tungsten, platinum, iridium, aluminum, and beryllium.

In this embodiment, the edge part 1351 includes an edge frame layer, which is disposed in the cavity 1330 and electrically connected to the electrode layer 1340; and an edge support layer, which is disposed in the cavity 1330 and on the edge frame layer, is connected to the electrode layer 1340, and the edge support layer overlaps with the edge frame layer.

In this embodiment, the edge frame layer and the edge support layer may be made of different materials. According to another embodiment, an edge frame layer and an edge support layer may be made of the same material.

In this embodiment, the edge frame layer may be made of a material including a metal, and the edge support layer may be made of a material including a non-metallic material. According to another embodiment, an edge frame layer may be made of a material including a metal, and an edge support layer may include a medium including air, i.e., an air layer. According to another embodiment, an edge frame layer may be made of a material including a metal, and an edge support layer may include a medium including vacuum, i.e., a vacuum layer. According to another embodiment, an edge frame layer may be made of a material including a metal, and an edge support layer may be made of a material including a metal.

In this embodiment, the extension part may have a thickness equal to a thickness of the edge part 1351.

In this embodiment, the edge extension layer 1353 may be made of a material including a metal. In this embodiment, the edge extension layer 1353 may be made of a material including, but not limited to, at least one of molybdenum, ruthenium, tungsten, platinum, iridium, aluminum, and beryllium.

In this embodiment, the compound support layer 1355 may include a medium including a non-metallic material. In this embodiment, the compound support layer 1355 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a first compound support layer of an extension part under a piezoelectric layer may include a medium of vacuum, i.e., a vacuum layer. According to another embodiment, a first compound support layer of an extension part under a piezoelectric layer may include a medium of air, i.e., an air layer.

In this embodiment, the compound support layer 1355 may have a thickness greater than a thickness of the edge support layer. According to another embodiment, a first compound support layer of an extension part may have a thickness equal to a thickness of an edge support layer of an edge part. According to another embodiment, a first compound support layer of an extension part may have a thickness less than a thickness of an edge support layer of an edge part.

In this embodiment, the edge extension layer 1357 may be made of a material including a metal. In this embodiment, the edge extension layer 1357 may be made of a material including, but not limited to, at least one of molybdenum, ruthenium, tungsten, platinum, iridium, aluminum, and beryllium.

In this embodiment, the compound support layer 1359 may include a medium including a non-metallic material. In this embodiment, the compound support layer 1359 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a second compound support layer of an extension part under a piezoelectric layer may include a medium of vacuum, i.e., a vacuum layer. According to another embodiment, a second compound support layer of an extension part under a piezoelectric layer may include a medium of air, i.e., an air layer.

In this embodiment, the compound support layer 1359 may have a thickness greater than a thickness of the edge support layer. According to another embodiment, a second compound support layer of an extension part may have a thickness equal to a thickness of an edge support layer of na edge part. According to another embodiment, a second compound support layer of an extension part may have a thickness less than a thickness of an edge support layer of an edge part.

In this embodiment, the edge extension layer 1353 has no overlap with the edge extension layer 1357. In this embodiment, the edge extension layer 1353 and the edge extension layer 1357 are disposed at two sides of the electrode layer 1340.

In this embodiment, the piezoelectric layer 1360 is a flat layer, and further covers the upper surface side of the intermediate layer 1320. In this embodiment, the piezoelectric layer 1360 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 1360 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 1360 includes crystal grains, which form a crystal having a full width at half maximum of rocking curve less than 2.5 degrees.

It should be noted that, formation of the piezoelectric layer 1360 on a plane may allow the piezoelectric layer 1360 not to include a crystal grain which suffers from a significant change to its orientation, thereby raising the electro-mechanical coupling factor of the resonance device and the Q value of the resonance device.

In this embodiment, the electrode layer 1370 may be made of a material including, but not limited to, at least one of molybdenum, ruthenium, tungsten, platinum, iridium, aluminum, and beryllium.

In this embodiment, the electrode layer 1340 has an overlap with the electrode layer 1370 that is disposed in the cavity 1330; and the electrode layer 1370 has an overlap with the electrode layer 1340 that is disposed above and corresponding to the cavity 1330.

In this embodiment, the first overlap has a width equal to a width of the edge part 1351, and the second overlap has a width equal to a width of the edge part 1351.

Figure 13b is a schematic structural top view of a bulk acoustic wave resonance device 1300 according to an embodiment of the present disclosure.

As shown in Figure 13b, in this embodiment, the edge part 1351 is in an annular shape. In this embodiment, the edge part 1351 is in an octagonal shape. It should be noted that, known edge parts of other shapes, such as, hexagons, pentagons, etc., may also be applied to the embodiments of the present disclosure. In this embodiment, the extension part is adjacent to six sides of the edge part 1351, and the edge extension layer 1353 is adj acent to a first side, a second side and a third side, the edge extension layer 1357 is adjacent to a fourth side, a fifth side and a sixth side, and the first side, the second side and the third side are disposed at a first end of the electrode layer 1340, the fourth side, the fifth side and the sixth side are disposed at a second end of the electrode layer 1340.

Figure 14a is a schematic structural view of section A of a bulk acoustic wave resonance device 1400 according to an embodiment of the present disclosure.

As shown in Figure 14a, an embodiment of the present disclosure provides a bulk acoustic wave resonance device 1400 including: a substrate 1410; an intermediate layer 1420, which is disposed on the substrate 1410 and includes, at an upper surface side of the intermediate layer 1420, a cavity 1430 and a groove 1431, and the groove 1431 is disposed at one side of the cavity 1430and communicates with the cavity 1430, which has a depth less than a depth of the cavity 1430; an electrode layer 1440, which is disposed in the cavity 1430; a composite structure 1450 including: an edge part 1451 that is disposed in the cavity 1430, where the electrode layer 1440 is disposed at an inner side (i.e., a side directing to the central axis of the bulk acoustic wave resonance device 1400) of the edge part 1451; a first extension part (not marked), which has a first end connected to the edge part 1451 and a second end opposite to the first end and disposed in the groove 1431, has a thickness equal to the depth of the groove 1431 and is disposed at an outer side (i.e., a side opposite to the side directing to the central axis of the bulk acoustic wave resonance device 1400) of the edge part 1451; wherein, the first extension part includes an edge extension layer 1453 and a compound support layer 1455, where the edge extension layer 1453 is electrically connected to the edge part 1451, and the compound support layer 1455 is disposed on the edge extension layer 1453 and connected to the edge part 1451, and the compound support layer 1455 overlaps with the edge extension layer 1453; a piezoelectric layer 1460, which is disposed on the electrode layer 1440, the edge structure 1451, the compound support layer 1455 and the intermediate layer 1420 and covers the cavity 1430, includes a first side 1461 and a second side 1463 opposite to the first side 1461, where the electrode layer 1440, the composite structure 1450 and the intermediate layer 1420 are disposed at the first side 1461; an electrode layer 1470, which is disposed at the second side 1463 on the piezoelectric layer 1460, has an overlap with the edge structure 1451, where the electrode layer 1470 has a first overlap with the edge extension layer 1453 and the compound support layer 1455; a composite structure 1480 including: an edge part 1481 that is disposed at the second side 1463 on the piezoelectric layer 1460, has an overlap with the electrode layer 1440, where the electrode layer 1470 is disposed at an inner side of the edge part 1481; a second extension part (not marked), which is disposed at the second side 1463 on the piezoelectric layer 1460 and at an outer side of the edge part 1481, is connected to the edge part 1481; wherein, the second extension part includes an edge extension layer 1483 and a compound support layer 1485, where the edge extension layer 1483 is disposed at the second side 1463 over the piezoelectric layer 1460 and electrically connected to the edge part 1481, and the compound support layer 1485 is disposed at the second side 1463 on the piezoelectric layer 1460 and between the piezoelectric layer 1460 and edge extension layer 1483, and the compound support layer 1485 is connected to the edge part 1481 and overlaps with the edge extension layer 1483, where the edge extension layer 1483 and the compound support layer 1485 have a second overlap with the electrode layer 1440.

It should be noted that, the compound support layer 1455 may raise a thickness of a medium between the electrode layer 1470 and the edge extension layer 1453, where the compound support layer 1455 is adapted to lower fringe capacitance between the electrode layer 1470 and the edge extension layer 1453, and the compound support layer 1485 may raise a thickness of a medium between the electrode layer 1440 and the edge extension layer 1483, where the compound support layer 1485 is adapted to lower fringe capacitance between the electrode layer 1440 and the edge extension layer 1483, so that electro-mechanical coupling factor of the resonance device may be improved.

In addition, the edge part 1451 and the first extension part form a first reflection structure disposed at an outer side of the electrode layer 1440, and the edge part 1481 and the second extension part form a second reflection structure disposed at an outer side of the electrode layer 1470, to reflect acoustic waves in the resonance region, resulting in preventing leaky waves and improving the Q value.

In this embodiment, the substrate 1410 may be made of a material including, but not limited to, at least one of silicon, silicon carbide, glass, gallium arsenide, gallium nitride, and ceramic.

In this embodiment, the intermediate layer 1420 may be made of a material including, but not limited to, at least one of polymers, insulating dielectric, and polysilicon. In this embodiment, the polymers may include, but be not limited to, at least one of benzocyclobutene (i.e., BCB), photosensitive epoxy resin photoresist (e.g., SU-8), and polyimide. In this embodiment, the insulating dielectric may include, but be not limited to, at least one of aluminum nitride, silicon dioxide, silicon nitride, and titanium oxide.

In this embodiment, the electrode layer 1440 may be made of a material including, but not limited to, at least one of molybdenum, ruthenium, tungsten, platinum, iridium, aluminum, and beryllium.

In this embodiment, the edge part 1451 includes a first edge frame layer, which is disposed in the cavity 1130 and electrically connected to the electrode layer 1440; and a first edge support layer, which is disposed on the first edge frame layer in the cavity 1130 and is connected to the electrode layer 1440, and the first edge support layer overlaps with the first edge frame layer.

In this embodiment, the first edge frame layer and first the edge support layer may be made of different materials. According to another embodiment, a first edge frame layer and a first edge support layer may be made of the same material.

In this embodiment, the first edge frame layer may be made of a material including a metal, and the first edge support layer may be made of a material including a non-metallic material. According to another embodiment, a first edge frame layer may be made of a material including a metal, and a first edge support layer may include a medium including air, i.e., an air layer. According to another embodiment, a first edge frame layer may be made of a material including a metal, and a first edge support layer may include a medium including vacuum, i.e., a vacuum layer. According to another embodiment, a first edge frame layer may be made of a material including a metal, and a first edge support layer may be made of a material including a metal.

In this embodiment, the first extension part may have a thickness equal to a thickness of the edge part 1451.

In this embodiment, the edge extension layer 1453 may be made of a material including a metal. In this embodiment, the edge extension layer 1453 may be made of a material including, but not limited to, at least one of molybdenum, ruthenium, tungsten, platinum, iridium, aluminum, and beryllium.

In this embodiment, the compound support layer 1455 may include a medium including a non-metallic material. In this embodiment, the compound support layer 1455 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a first compound support layer of a first extension part under a piezoelectric layer may include a medium of vacuum, i.e., a vacuum layer. According to another embodiment, a first compound support layer of a first extension part under a piezoelectric layer may include a medium of air, i.e., an air layer.

In this embodiment, the compound support layer 1455 may have a thickness greater than a thickness of the first edge support layer. According to another embodiment, a first compound support layer of a first extension part may have a thickness equal to a thickness of a first edge support layer of a first edge part. According to another embodiment, a first compound support layer of a first extension part may have a thickness less than a thickness of a first edge support layer of a first edge part.

In this embodiment, the piezoelectric layer 1460 is a flat layer, and further covers the upper surface side of the intermediate layer 1420. In this embodiment, the piezoelectric layer 1460 may be made of a material including, but not limited to, at least one of aluminum nitride, alloys of aluminum nitride, gallium nitride, zinc oxide, lithium tantalate, lithium niobate, lead zirconate titanate, and lead magnesium niobate-lead titanate.

In this embodiment, the piezoelectric layer 1460 includes crystal grains. The crystal grains include a first crystal grain and a second crystal grain, and the first crystal grain and the second crystal grain are two arbitrary crystal grains among the crystal grains. Crystal orientation, crystal plane, etc., of a crystal grain may be represented based on a coordinate system.

In this embodiment, the first crystal grain may be represented based on a first stereoscopic coordinate system, and the second crystal grain may be represented based on a second stereoscopic coordinate system. And, the first stereoscopic coordinate system includes at least a first coordinate axis along a first direction and a third coordinate axis along a third direction. And, the second stereoscopic coordinate system includes at least a second coordinate axis along a second direction and a fourth coordinate axis along a fourth direction. And, the first coordinate axis corresponds to a height of the first crystal grain, and the second coordinate axis corresponds to a height of the second crystal grain.

In this embodiment, the first direction may be the same as or opposite to the second direction. It should be noted that, the first direction being the same as the second direction means that an included angle between a vector along the first direction and a vector along the second direction may be within a range from 0 degree to 5 degrees, and the first direction being opposite to the second direction means that the included angle between the vector along the first direction and the vector along the second direction may be within a range from 175 degrees to 180 degrees.

According to another embodiment, the first stereoscopic coordinate system is an ac stereoscopic coordinate system, and the first coordinate axis is a first c-axis, and the third coordinate axis is a first a-axis. The second stereoscopic coordinate system is an ac stereoscopic coordinate system, and the second coordinate axis is a second c-axis, and the fourth coordinate axis is a second a-axis. And, the first c-axis and the second c-axis have the same or opposite orientations.

According to another embodiment, the first stereoscopic coordinate system further includes a fifth coordinate axis along a fifth direction, and the second stereoscopic coordinate system further includes a sixth coordinate axis along a sixth direction. According to another embodiment, the first direction is the same as or opposite to the second direction, and the third direction is the same as or opposite to the fourth direction. It should be noted that, the third direction being the same as the fourth direction means that an included angle between a vector along the third direction and a vector along the fourth direction may be within a range from 0 degree to 5 degrees, and the third direction being opposite to the fourth direction means that the included angle between the vector along the third direction and the vector along the fourth direction may be within a range from 175 degrees to 180 degrees.

According to another embodiment, the first stereoscopic coordinate system is an xyz stereoscopic coordinate system, and the first coordinate axis is a first z-axis, the third coordinate axis is a first y-axis, and the fifth coordinate axis is a first x-axis. And, the second stereoscopic coordinate system is an xyz stereoscopic coordinate system, and the second coordinate axis is a second z-axis, the fourth coordinate axis is a second y-axis, and the sixth coordinate axis is a second x-axis. According to another embodiment, the first z-axis and the second z-axis have the same orientation, and the first y-axis and the second y-axis have the same orientation. According to another embodiment, the first z-axis and the second z-axis have opposite orientations, and the first y-axis and the second y-axis have opposite orientations. According to another embodiment, the first z-axis and the second z-axis have the same orientation, and the first y-axis and the second y-axis have opposite orientations. According to another embodiment, the first z-axis and the second z-axis have opposite orientations, and the first y-axis and the second y-axis have the same orientation.

In this embodiment, the piezoelectric layer 1460 includes crystal grains, which form a crystal having a full width at half maximum of rocking curve less than 2.5 degrees.

It should be noted that, formation of the piezoelectric layer 1460 on a plane may allow the piezoelectric layer 1460 not to include a crystal grain which suffers from a significant change to its orientation, thereby raising the electro-mechanical coupling factor of the resonance device and the Q value of the resonance device.

In this embodiment, the electrode layer 1470 may be made of a material including, but not limited to, at least one of molybdenum, ruthenium, tungsten, platinum, iridium, aluminum, and beryllium.

In this embodiment, the electrode layer 1440 has an overlap with the electrode layer 1470 that is disposed in the cavity 1430; and the electrode layer 1470 has an overlap with the electrode layer 1440 that is disposed above and corresponding to the cavity 1430.

In this embodiment, the edge part 1481 includes a second edge frame layer, which is disposed at the second side 1463 above the piezoelectric layer 1460 and electrically connected to the electrode layer 1470; and a second edge support layer, which is disposed at the second side 1463 above the piezoelectric layer 1460 and between the piezoelectric layer 1460 and the second edge frame layer, is connected to the electrode layer 1470, and the second edge support layer overlaps with the second edge frame layer.

In this embodiment, the second edge frame layer and the second edge support layer may be made of different materials. According to another embodiment, a second edge frame layer and a second edge support layer may be made of the same material.

In this embodiment, the second edge frame layer may be made of a material including a metal, and the second edge support layer may be made of a material including a non-metallic material. According to another embodiment, a second edge frame layer may be made of a material including a metal, and a second edge support layer may include a medium including air, i.e., an air layer. According to another embodiment, a second edge frame layer may be made of a material including a metal, and a second edge support layer may include a medium including vacuum, i.e., a vacuum layer. According to another embodiment, a second edge frame layer may be made of a material including a metal, and a second edge support layer may be made of a material including a metal.

In this embodiment, the second extension part may have a thickness equal to a thickness of the edge part 1481.

In this embodiment, the edge extension layer 1483 may be made of a material including a metal. In this embodiment, the edge extension layer 1483 may be made of a material including, but not limited to, at least one of molybdenum, ruthenium, tungsten, platinum, iridium, aluminum, and beryllium.

In this embodiment, the compound support layer 1485 may include a medium including a non-metallic material. In this embodiment, the compound support layer 1485 may include a medium including, but not limited to, at least one of silicon dioxide, silicon oxycarbide, silicon oxyfluoride, and polymers. And, the polymers may include, but be not limited to, at least one of benzocyclobutene (i.e., BCB), photosensitive epoxy resin photoresist (e.g., SU-8), and polyimide. According to another embodiment, a second compound support layer of a second extension part on a piezoelectric layer may include a medium of vacuum, i.e., a vacuum layer. According to another embodiment, a second compound support layer of a second extension part on a piezoelectric layer may include a medium of air, i.e., an air layer.

In this embodiment, the compound support layer 1485 may have a thickness greater than a thickness of the second edge support layer. According to another embodiment, a second compound support layer of a second extension part may have a thickness equal to a thickness of a second edge support layer of a second edge part. According to another embodiment, a second compound support layer of a second extension part may have a thickness less than a thickness of a second edge support layer of a second edge part.

In this embodiment, the first extension part has no overlap with the second extension part. In this embodiment, the first extension part and the second extension part are disposed at two sides of an overlap between the electrode layer 1440 and the electrode layer 1470.

In this embodiment, the first overlap has a width equal to a width of the edge part 1451, and the second overlap has a width equal to a width of the edge part 1481.

Figure 14b is a schematic structural top view of a bulk acoustic wave resonance device 1400 according to an embodiment of the present disclosure.

As shown in Figure 14b, in this embodiment, the edge part 1451 and the edge part 1481 overlap partially and form a frame structure. In this embodiment, the frame structure is in an octagonal shape. It should be noted that, known frame structures of other shapes, such as, hexagons, pentagons, etc., may also be applied to the embodiments of the present disclosure. In this embodiment, the first extension part is adjacent to one side of the edge part 1451, and the second extension part is adjacent to one side of the edge part 1481.

Figure 15 is a schematic structural view of a wireless communication device 1500. As shown in Figure 15, the wireless communication device 1500 may include a radio frequency front-end device 1510, a baseband processing device 1530 and an antenna 1550, and the radio frequency front-end device 1510 has a first end connected to the baseband processing device 1530 and a second end connected to the antenna 1550. And, the radio frequency front-end device 1510 may include a filtering device 1511, a filtering device 1513, a multiplexing device 1515, a power amplifier device 1517 and a low noise amplifier device 1519, and the filtering device 1511 is electrically connected to the power amplifier device 1517, and the filtering device 1513 is electrically connected to the low noise amplifier device 1519, the multiplexing device 1515 includes at least one transmitting filtering device (not shown) and at least one receiving filtering device (not shown). And, the filtering device 1511 includes at least one bulk acoustic wave resonance device provided by one of the above embodiments, the filtering device 1513 includes at least one bulk acoustic wave resonance device provided by one of the above embodiments. And, at least one transmitting filtering device includes at least one bulk acoustic wave resonance device provided by one of the above embodiments, or at least one receiving filter device includes at least one bulk acoustic wave resonance device provided by one of the above embodiments.

In summary, the bulk acoustic wave resonance device provided in the embodiments of the present disclosure includes a composite structure, which is electrically connected to a first electrode layer or an edge structure of the first electrode, and includes an edge extension layer and a compound support layer. The compound support layer may raise a thickness of a medium between the edge extension layer and a second electrode layer, where the compound support layer is adapted to lower fringe capacitance and improve electro-mechanical coupling factor. In addition, the edge structure and the composite structure may form a reflection structure, which is disposed at an outer side of the electrode layer, to reflect acoustic waves in the resonance region, resulting in preventing leaky waves and improving the Q value.

It should be understood that examples and embodiments herein are only exemplary, and various modifications and corrections may be made without departing from the spirit and scope of the present disclosure defined by the present application and the attached claims.

## Claims

1. A bulk acoustic wave resonance device, **characterized by** comprising:
a first layer, which comprises a cavity;
a first electrode layer, which has at least one end disposed in the cavity;
a piezoelectric layer, which is disposed on the first electrode layer and covers the cavity; wherein the piezoelectric layer comprises a first side and a second side opposite to the first side along a vertical direction, and the first electrode layer is disposed at the first side;
a second electrode layer, which is disposed at the second side and on the piezoelectric layer; wherein the second electrode layer has an overlap with the first electrode layer, where the overlap is disposed above and corresponding to the cavity; and
a first composite structure, which is disposed at the first side and contacts the piezoelectric layer, where the first composite structure is adjacent to the first electrode layer along a horizontal direction; wherein a first end of the first composite structure, which is close to the first electrode layer, is disposed in the cavity, and a second end of the first composite structure, which is far away from the first electrode layer and opposite to the first end along a horizontal direction, is embedded in the first layer; wherein, the first composite structure comprises a first edge extension layer and a first support layer disposed between the piezoelectric layer and the first edge extension layer, where the first support layer is adapted to lower fringe capacitance.

2. The bulk acoustic wave resonance device according to claim 1, **characterized in that** the first edge extension layer is made of a material comprising a metal.

3. The bulk acoustic wave resonance device according to claim 1, **characterized in that** the first support layer may comprise a medium comprising one of non-metallic materials, air, and vacuum.

4. The bulk acoustic wave resonance device according to claim 1, **characterized in that** the first electrode layer is in a polygonal shape, and the first composite structure is adjacent to at least one side of the first electrode layer.

5. The bulk acoustic wave resonance device according to claim 1, **characterized by** further comprising a first edge structure, which is disposed at the first side and contacts the piezoelectric layer, where the first edge structure comprises a third side and a fourth side opposite to the third side along a horizontal direction; wherein the first electrode layer is disposed at the third side, and the first composite structure is disposed at the fourth side.

6. The bulk acoustic wave resonance device according to claim 5, **characterized in that** the first edge structure encloses at least part of the first electrode layer.

7. The bulk acoustic wave resonance device according to claim 5, **characterized in that** the first electrode layer is disposed at an inner side of the first edge structure, and the first composite structure is disposed at an outer side of the first edge structure.

8. The bulk acoustic wave resonance device according to claim 5, **characterized in that** the first edge structure comprises a first edge frame layer, which is made of a material comprising a metal, connected to the first electrode layer, and further connected to the first edge extension layer.

9. The bulk acoustic wave resonance device according to claim 8, **characterized in that** the first edge structure further comprises a first edge support layer, which contacts the piezoelectric layer and is disposed between the piezoelectric layer and the first edge frame layer, where the first edge support layer is adapted to lower a resonance frequency of a spurious resonance excited due to the first edge frame layer.

10. The bulk acoustic wave resonance device according to claim 9, **characterized in that** the first edge support layer comprises a medium comprising one of non-metallic materials, air, and vacuum.

11. The bulk acoustic wave resonance device according to claim 5, **characterized in that** the first edge structure comprises a first overlap with the second electrode layer.

12. The bulk acoustic wave resonance device according to claim 5, **characterized in that** the first composite structure comprises a second overlap with the second electrode layer, and the second overlap has a width equal to a width of the first edge structure.

13. The bulk acoustic wave resonance device according to claim 5, **characterized in that** the first edge structure is in a polygonal shape, and the first composite structure is adjacent to at least one side of the first edge structure.

14. The bulk acoustic wave resonance device according to claim 1, **characterized in that** the first composite structure further comprises a first edge part, which comprises a fifth side and a sixth side opposite to the fifth side along a horizontal direction, where the first electrode layer is disposed at the fifth side, the first edge extension layer and the first support layer are disposed at the sixth side.

15. The bulk acoustic wave resonance device according to claim 14, **characterized in that** the first edge part has a thickness equal to a sum of a thickness of the first edge extension layer and a thickness of the first support layer.

16. The bulk acoustic wave resonance device according to claim 14, **characterized in that** the first edge part encloses at least part of the first electrode layer.

17. The bulk acoustic wave resonance device according to claim 14, **characterized in that** the first electrode layer is disposed at an inner side of the first edge part, and the first edge extension layer and the first support layer are disposed at an outer side of the first edge part.

18. The bulk acoustic wave resonance device according to claim 14, **characterized in that** the first edge part comprises a third overlap with the second electrode layer.

19. The bulk acoustic wave resonance device according to claim 14, **characterized in that** the first edge extension layer comprises a fourth overlap with the first support layer and the second electrode layer, and the fourth overlap has a width equal to a width of the first edge part.

20. The bulk acoustic wave resonance device according to claim 14, **characterized in that** the first edge part is in a polygonal shape, and the first edge extension layer and the first support layer are adjacent to at least one side of the first edge part.

21. A bulk acoustic wave resonance device, **characterized by** comprising:
a first layer, which comprises a cavity;
a first electrode layer, which has at least one end disposed in the cavity;
a piezoelectric layer, which is disposed on the first electrode layer and covers the cavity, and the piezoelectric layer comprises a first side and a second side opposite to the first side along a vertical direction, where the first electrode layer is disposed at the first side;
a second electrode layer, which is disposed at the second side and on the piezoelectric layer; wherein, the second electrode layer has an overlap with the first electrode layer, where the overlap is disposed above and corresponding to the cavity; and
a second composite structure, which is disposed at the second side and contacts the piezoelectric layer, where the second composite structure is adjacent to the second electrode layer along a horizontal direction and does not overlap with or partially overlaps with the first electrode layer; wherein, the second composite structure comprises a second edge extension layer and a second support layer disposed between the piezoelectric layer and the second edge extension layer, where the second support layer is adapted to lower fringe capacitance.

22. The bulk acoustic wave resonance device according to claim 21, **characterized in that** the second edge extension layer is made of a material comprising a metal.

23. The bulk acoustic wave resonance device according to claim 21, **characterized in that** the second support layer comprises a medium comprising one of non-metallic materials, air, and vacuum.

24. The bulk acoustic wave resonance device according to claim 21, **characterized in that** the second electrode layer is in a polygonal shape, and the second composite structure is adjacent to at least one side of the second electrode layer.

25. The bulk acoustic wave resonance device according to claim 21, **characterized by** further comprising a second edge structure, which is disposed at the second side and contacts the piezoelectric layer, and the second edge structure comprises a third side and a fourth side opposite to the third side along a horizontal direction, where the second electrode layer is disposed at the third side, and the second composite structure is disposed at the fourth side.

26. The bulk acoustic wave resonance device according to claim 25, **characterized in that** the second edge structure encloses at least part of the second electrode layer.

27. The bulk acoustic wave resonance device according to claim 25, **characterized in that** the second electrode layer is disposed at an inner side of the second edge structure, and the second composite structure is disposed at an outer side of the second edge structure.

28. The bulk acoustic wave resonance device according to claim 25, **characterized in that** the second edge structure comprises a second edge frame layer, which is made of a material comprising a metal, where the edge frame layer is connected to the second electrode layer and further connected to the second edge extension layer.

29. The bulk acoustic wave resonance device according to claim 28, **characterized in that** the second edge structure further comprises a second edge support layer, which contacts the piezoelectric layer and is disposed between the piezoelectric layer and the second edge frame layer, where the second edge support layer is adapted to lower a resonance frequency of a spurious resonance excited due to the second edge frame layer.

30. The bulk acoustic wave resonance device according to claim 29, **characterized in that** the second edge support layer comprises a medium comprising one of non-metallic materials, air, and vacuum.

31. The bulk acoustic wave resonance device according to claim 25, **characterized in that** the second edge structure comprises a first overlap with the first electrode layer.

32. The bulk acoustic wave resonance device according to claim 25, **characterized in that** the second composite structure comprises a second overlap with the first electrode layer, and the second overlap has a width equal to a width of the second edge structure.

33. The bulk acoustic wave resonance device according to claim 25, **characterized in that** the second edge structure is in a polygonal shape, and the second composite structure is adjacent to at least one side of the second edge structure.

34. The bulk acoustic wave resonance device according to claim 21, **characterized in that** the second composite structure further comprises a second edge part, which comprises a fifth side and a sixth side opposite to the fifth side along a horizontal direction, where, the second electrode layer is disposed at the fifth side, and the second edge extension layer and the second support layer are disposed at the sixth side.

35. The bulk acoustic wave resonance device according to claim 34, **characterized in that** the second edge part has a thickness equal to a sum of a thickness of the second edge extension layer and a thickness of the second support layer.

36. The bulk acoustic wave resonance device according to claim 34, **characterized in that** the second edge part encloses at least part of the second electrode layer.

37. The bulk acoustic wave resonance device according to claim 34, **characterized in that** the second electrode layer is disposed at an inner side of the second edge part, and the second edge extension layer and the second support layer are disposed at an outer side of the second edge part.

38. The bulk acoustic wave resonance device according to claim 34, **characterized in that** the second edge part comprises a third overlap with the first electrode layer.

39. The bulk acoustic wave resonance device according to claim 34, **characterized in that** the second edge extension layer comprises a fourth overlap with the second support layer and the first electrode layer, and the fourth overlap has a width equal to a width of the second edge part.

40. The bulk acoustic wave resonance device according to claim 34, **characterized in that** the second edge part is in a polygonal shape, and the second edge extension layer and the second support layer are adjacent to at least one side of the second edge part.

41. The bulk acoustic wave resonance device according to claim 1, **characterized in that** the first layer comprises an intermediate layer, which comprises the cavity and is made of a material comprising at least one of polymers, insulating dielectric, and polysilicon.

42. A filtering device, **characterized by** comprising at least one bulk acoustic wave resonance device according to any one of claims 1 to 41.

43. A radio frequency front-end device, **characterized by** comprising a power amplifier device and at least one filtering device according to claim 42, and the power amplifier device is connected to the filtering device.

44. A radio frequency front-end device, **characterized by** comprising a low noise amplifier device and at least one filtering device according to claim 42, and the low noise amplifier device is connected to the filtering device.

45. A radio frequency front-end device, **characterized by** comprising a multiplexing device comprising at least one filtering device according to claim 42.
